# EUROPEAN PATENT APPLICATION

(11) **EP 4 624 155 A1**
(43) Date of publication of application: **01.10.2025**
(21) Application number: 24167885.3
(22) Date of filing: 29.03.2024
(51) Int. Cl.: B32B 37/10, H01L 31/048, B30B 15/06

(54) **MEMBRANELESS LAMINATOR GROUP FOR MAKING IRREGULAR MULTILAYER PHOTOVOLTAIC PANELS, PLANT WITH SUCH MEMBRANLESS LAMINATOR GROUP AND ASSOCIATED METHOD OF MANUFACTURING**

(71) Applicant: Teknisolar Ltd, Warrington, Cheshire WA3 7QX (GB)
(72) Inventor: DE LEONIBUS, Vittore, 66054 Vasto (CH) (IT); FABIANI, Mariano, 66054 Vasto (CH) (IT)
(74) Representative: PGA S.p.A., Milano, Succursale di Lugano

(57) **Abstract**

A membraneless laminator group (1) for making irregular multilayer photovoltaic panels (P) of the type having at least one flat portion (P1) and at least one protruding portion (P2) developing transversally with respect to the flat portion (P1), such as a protruding frame or one or more protruding edges, comprises at least one lamination chamber (2) configured to operate in vacuum which includes: an abutment base (3) provided with a supporting plane (3a) for supporting at least one panel (P); a movable cover element (4) movable with respect to the base (3) between an open position, wherein at least one panel (P) can be inserted into the chamber (2) or removed from the latter, and a closed position, wherein the movable cover element (4) engages the base (3) by defining a sealable space (5), closed and isolated from the outside; a movable rigid plane (6) located inside the chamber (2) and movable between a raised position, wherein the movable rigid plane (6) is spaced from the supporting plane (3a) of the base (3) and a lowered position, wherein the movable rigid plane (6) is close to the supporting plane (3a) of the abutment base (3); in an operating condition with an irregular multilayer photovoltaic panel (P) resting on the supporting plane (3a) of the base (3) and the movable rigid plane (6) positioned in the lowered position, the panel (P) is interposed between the movable rigid plane (6) and the supporting plane (3a) of the abutment base (3) and pressed between the movable rigid plane (6) and the supporting pane (3a) of the base (3); one mould template (7) engageable or engaged to the movable rigid plane (6) so that to be located between the movable rigid plane (6) and the supporting plane (3a) of the base (3) on which the panel (P) to be manufactured is leaning on wherein the mould template (7) has a shape configured to adapt the movable rigid plane (6) to the panel (P) and is configured to transmit a pressure force from the movable rigid plane (6) to the flat portion (P1) of the panel (P) to be manufactured when the movable rigid plane (6) is positioned in the lowered position.

## Description

### TECHNICAL FIELD

The present disclosure generally relates to a membranless laminator group for making irregular multilayer photovoltaic panels of the type having at least one flat portion and at least one protruding portion developing transversally with respect to the flat portion.

The present disclosure also relates to a plant of manufacturing irregular multilayer photovoltaic panels of the type having at least one flat portion and at least one protruding portion developing transversally with respect to the flat portion wherein the above mentioned membranless laminator group is provided.

It is also the subject of this disclosure a method of manufacturing irregular multilayer photovoltaic panels of the type having at least one flat portion and at least one protruding portion developing transversally with respect to the flat portion by the above mentioned membranless laminator group and/or the above mentioned plant of manufacturing.

### BACKGROUND

As it is well known, the term or expression "laminated panel" generally means a "sandwich" structure wherein a plurality of layers are placed on top of each other.

With reference to a traditional flat crystalline photovoltaic panel, it may be formed by the following succession of layers, starting from the outer or top face, namely the face adapted to be exposed to the sun, to the inner or back face, namely the face arranged to be faced with the roof or a properly supporting structure:
- a sheet of glass;
- a sheet of ethylene vinyl acetate or EVA lamina;
- a layer of mono or polycrystalline cells electrically connected to each other;
- an EVA lamina to protect the cells;
- a plastic backing cover sheet, generally called "backsheet", or glass lamina.

A classic flat thin-film panel may also be formed by the following succession of layers starting from the outer or top face, namely the face adapted to be exposed to the sun, to the inner or back face, namely the face arranged to be faced with the roof or a properly supporting structure:
- a sheet of glass;
- a transparent and conductive coating on the inner face of the outer glass;
- a succession of thin layers suitably arranged and formed to work as solar cells;
- a reflective and conductive coating;
- a lamina of EVA or other type of encapsulant;
- a rear cover glass.

Usually, glass is used as the base on which a thin lamina of EVA is laid on. On top of the EVA lamina, cells are placed facing down with the photosensitive side facing downwards. Another lamina of EVA is placed on the cells and a lamina of plastic insulating backsheet material, PET or similar, or another lamina of glass is placed on the last lamina of EVA laid on. The sandwich so formed is sent to the laminator which is a machine provided with a lamination chamber maintained at a temperature of 150-160°C in which, after vacuum is created in a few minutes, the polymerization of EVA laminas or other plastic interlayer encapsulants is determined. Strong pressure is exerted on the flat photovoltaic panel thus treated to compact all the layers. The obtained compressed and compacted photovoltaic panel then completes the curing cycle, at about 150°C, under vacuum and under the action of continuous mechanical compression. According to this technology, the manufactured flat photovoltaic panel is capable of resist the weather for many years, a time of not less than at least 25 to 30 years.

In terms of processes and methods for manufacturing the above cited flat multilayer photovoltaic panels the know techniques and the known laminator are basically based on the following phases:
a) evacuating the air trapped between layers;
b) heating and melting EVA or any other encapsulant layer;
c) sealing the edges by application of pressure forces, also called compression;
d) maintaining a high temperature at a set point for a certain length of time while applying compression of the layers in order to obtain the polymerization;
e) cooling, if necessary while applying compression of the layers.

During the evacuation air phase, the air trapped between the layers is removed by creating a vacuum (approximately 1 mbar) in a designated lamination chamber. Each flat multilayer photovoltaic panel is also usually heated by conduction on a supporting plane and/or through a rigid mobile compression plane of the lamination chamber.

In detail, the evacuation phase is usually carried out by keeping each flat multilayer photovoltaic panel at a relatively low temperature for avoid premature melting of the EVA layers. Evacuation is necessary to avoid the formation of bubbles due to the air naturally trapped in the panel and the peroxide generated by the curing of EVA.

With reference to compression and polymerization phases of the plastic film contained in the panel, both of them are normally carried out into the designated lamination chamber after the evacuation and sealing phases are concluded. The usual technique provides that the polymerisation takes place at a temperature of 80°- 90° C. Under this temperature condition, pressure is applied to the upper face of each flat multilayer photovoltaic panel, thus triggering the adhesion of the EVA layers to the contiguous layers.

One example of a laminator plant for manufacturing flat multilayer photovoltaic panels is provided with at least one lamination chamber connected to a pump unit for selective evacuation of air in the chamber when airtightly closed.

The lamination chamber comprises an abutment base, of a known type, provided with a supporting plane which serves as a support and striker for the flat multilayer photovoltaic panels which are successively fed, and a movable cover element for opening and closing the lamination chamber upon action of known control units or devices. A rigid mobile plane is movable inside the lamination chamber between a raised position, wherein it is away from the flat multilayer photovoltaic panel to be manufactured which lies on the supporting plane of the abutment base and a lowered position, wherein it presses the flat multilayer photovoltaic panel against the supporting plane of the abutment base. The rigid mobile plane works as a compression heated element.

Examples of lamination chambers as the one briefly described can be found into the documents WO2017098465 and IT202000015955.

Irregular multilayer photovoltaic panels, different with respect to the traditional flat photovoltaic panels, also exist.

The term or expression "irregular multilayer photovoltaic panel" is intended as referring to a multilayer photovoltaic panel provided with at least one flat portion and one or more protruding portions developing transversally with respect to the flat portion, wherein the flat portion is defined by different layers properly superimposed to define a flat multilayer photovoltaic body which is fixed on a central flat portion of a supporting lamina whereas the protruding portions significantly project transversally from the sides and/or other parts of the central flat portion of such a supporting lamina. The irregular multilayer photovoltaic panels of a known type generally comprise a supporting lamina made of a press-folded metallic material. At least the long sides edges of such panels protrude from the central flat portion of the supporting lamina. Also the short side edges of such panels can protrude from the central flat portion of the supporting lamina. Irrespective of the number of the protruding side edges provided on the supporting lamina of the known panels, it should to note that the protruding edges are properly shaped to allow interlocking between adjacent panels during the installation procedure and so create a corresponding photovoltaic assembly.

Of course, the protruding edges can vary in relation to the needs and the different models of multilayer photovoltaic panels to be manufactured and they can project from the central flat portion of the supporting lamina upwards and/or downwards.

Also complex irregular multilayer photovoltaic assemblies exist. Generally, such assemblies can be provided with different flat portions, which can also be located at different levels, interspersed with, or at least partially surrounded by, protruding portions and/or recesses or depressions. Similar to the irregular multilayer photovoltaic panels, the irregular multilayer photovoltaic assemblies can be considered as a plurality of irregular photovoltaic panels engaged each other.

The known techniques and the known laminator implants are aimed to produce only traditional flat multilayer photovoltaic panels but do not lend themselves to the production of irregular multilayer photovoltaic panels or complex irregular multilayer photovoltaic assemblies such as the ones just described above provided with protruding portions and/o recesses or depressions.

In fact, current systems or techniques for the production of irregular multilayer photovoltaic panels or complex irregular multilayer photovoltaic assemblies first require that the flat portions of the photovoltaic panels be produced according to the traditional techniques for production of flat photovoltaic panels. These flat portions are then manually assembled, at a later stage, to a support structure or sheet provided with the corresponding interlocking projections.

This results in considerable excessive production and costs times, as well as a high probability of errors or defects in the assembly.

### BRIEF SUMMARY

It is an objective of the present disclosure to significantly reduce the time and the costs required for the production of irregular multilayer photovoltaic panels or irregular multilayer photovoltaic assemblies.

It is also an objective of the present disclosure automating the production of irregular multilayer photovoltaic panels or irregular multilayer photovoltaic assemblies.

It is further an objective of the present disclosure to eliminate any manual assembling step for the production of irregular multilayer photovoltaic panels or irregular multilayer photovoltaic assemblies.

It is also an objective of the present disclosure to eliminate or minimize any assembly error or defect.

Last but not least, it is an object of the present disclosure to provide a membraneless laminator group and a plant of manufacturing of a universal type, namely capable of producing different type of irregular multilayer photovoltaic panels or irregular multilayer photovoltaic assemblies with different configurations of the flat portions and the protruding portions.

In light of the disclosure set forth herein, and without limiting the disclosure in any way, in a 1^{st} aspect, which may be combined with any other aspect or portion thereof described herein, a membraneless laminator group (1) for making irregular multilayer photovoltaic panels (P) of the type having at least one flat portion (P1) and at least one protruding portion (P2) developing transversally with respect to the flat portion (P1), such as a protruding frame or one or more protruding edges, comprises at least one lamination chamber (2) configured to operate in vacuum, wherein the lamination chamber (2) comprises: an abutment base (3) provided with a supporting plane (3a) for supporting at least one irregular multilayer photovoltaic panel (P); a movable cover element (4) movable with respect to the abutment base (3) between an open position, wherein at least one irregular multilayer photovoltaic panel (P) can be inserted into the lamination chamber (2) or removed from the latter, and a closed position, wherein the movable cover element (4) engages the abutment base (3) by defining a sealable space (5), closed and isolated from the outside; a movable rigid plane (6) located inside the lamination chamber (2) and movable between a raised position, wherein the movable rigid plane (6) is spaced from supporting plane (3a) of the abutment base (3) and a lowered position, wherein the movable rigid plane (6) is close to the supporting plane (3a) of the abutment base (3); in an operating condition with an irregular multilayer photovoltaic panel (P) resting on the supporting plane (3a) of the abutment base (3) and the movable rigid plane (6) positioned in the lowered position, the irregular multilayer photovoltaic panel (P) being interposed between the movable rigid plane (6) and the supporting plane (3a) of the abutment base (3), in particular the irregular multilayer photovoltaic panel (P) being pressed between the movable rigid plane (6) and the supporting pane (3a) of the abutment base (3); at least one mould template (7) engageable or engaged to the movable rigid plane (6) so that to be located between the movable rigid plane (6) and the supporting plane (3a) of the abutment base (3) on which the irregular multilayer photovoltaic panel (P) to be manufactured is leaning on, the mould template (7) having a shape configured to adapt the movable rigid plane (6) to the irregular multilayer photovoltaic panel (P), the mould template (7) being configured to transmit a pressure force from the movable rigid plane (6) to the at least one flat portion (P1) of the irregular multilayer photovoltaic panel (P) to be manufactured when the movable rigid plane (6) is positioned in the lowered position.

In a further independent aspect 1^{st} bis, which can be combined with the previous aspect and/or any one of the following aspects, a membraneless laminator group (1) for making irregular multilayer photovoltaic panels (P) of the type having at least one flat portion (P1) and at least one protruding portion (P2) developing transversally with respect to the flat portion (P1), such as a protruding frame or one or more protruding edges, wherein the membraneless laminator group (1) comprising at least one lamination chamber (2) configured to operate in vacuum, comprises: an abutment base (3) provided with a supporting plane (3a) for supporting at least one irregular multilayer photovoltaic panel (P); a movable cover element (4) movable with respect to the abutment base (3) between an open position, wherein at least one irregular multilayer photovoltaic panel (P) can be inserted into the lamination chamber (2) or removed from the latter, and a closed position, wherein the movable cover element (4) engages the abutment base (3) by defining a sealable space (5), closed and isolated from the outside; a movable rigid plane (6) located inside the lamination chamber (2) and movable between a raised position, wherein the movable rigid plane (6) is spaced from the supporting plane (3a) of the abutment base (3) and a lowered position, wherein the movable rigid plane (6) is close to the supporting plane (3a) of the abutment base (3); in an operating condition with an irregular multilayer photovoltaic panel (P) resting on the supporting plane (3a) of the abutment base (3) and the movable rigid plane (6) positioned in the lowered position, the irregular multilayer photovoltaic panel (P) being interposed between the movable rigid plane (6) and the supporting plane (3a) of the abutment base (3), in particular the irregular multilayer photovoltaic panel (P) being pressed between the movable rigid plane (6) and the supporting plane (3a) of the abutment base (3); at least one mould template (7) engageable or engaged to the movable rigid plane (6) so that to be located between the movable rigid plane (6) and the supporting plane (3a) of the abutment base (3) on which the irregular multilayer photovoltaic panel (P) to be manufactured is leaning on, the mould template (7) having a shape configured to adapt the movable rigid plane (6) to the irregular multilayer photovoltaic panel (P), the mould template (7) being configured to transmit a pressure force from the movable rigid plane (6) to the at least one flat portion (P1) of the irregular multilayer photovoltaic panel (P) to be manufactured when the movable rigid plane (6) is in the lowered position; a floppy adaptive element (8) engageable or engaged at least on opposite sides (6a) of the movable rigid plane (6), the mould template (7) being interposed between the movable rigid plane (6) and the floppy adaptive element (8); in the open position of the movable cover element (4) and/or in the raised position of the movable rigid plane (6), the floppy adaptive element (8) hanging from the movable rigid plane (6) towards the supporting plane (3a) of the abutment base (3) so that to define an arched configuration with a convexity (8a) facing towards the supporting plane (3a) of the abutment base (3), in the lowered position of the movable rigid plane (6) the floppy adaptive element (8) being pressed between the mould template (7) and the irregular multilayer photovoltaic panel (P) to be manufactured, by defining a layer of seal which covers the at least one flat portion (P1) and, at least partially, the at least one protruding portion (P2) of the irregular multilayer photovoltaic panel (P) so as to evenly distribute the pressure forces on the flat portion (P1) of the irregular multilayer photovoltaic panel (P).

In a further independent aspect 1^{st} ter, which can be combined with the previous aspect and/or any one of the following aspects, a membraneless laminator group (1) for making irregular multilayer photovoltaic panels (P) of the type having at least one flat portion (P1) and at least one protruding portion (P2) developing transversally with respect to the flat portion (P1), such as a protruding frame or one or more protruding edges, comprises:
- at least one lamination chamber (2) configured to operate in vacuum, wherein the lamination chamber (2) comprises: an abutment base (3) provided with a supporting plane (3a) for supporting at least one irregular multilayer photovoltaic panel (P); a movable cover element (4) movable with respect to the abutment base (3) between an open position, wherein at least one irregular multilayer photovoltaic panel (P) can be inserted into the lamination chamber (2) or removed from the latter, and a closed position, wherein the movable cover element (4) engages the abutment base (3) by defining a sealable space (5), closed and isolated from the outside; a movable rigid plane (6) located inside the lamination chamber (2) and movable between a raised position, wherein the movable rigid plane (6) is spaced from the supporting plane (3a) of the abutment base (3) and a lowered position, wherein the movable rigid plane (6) is positioned close to the supporting plane (3a) of the abutment base (3); in an operating condition with an irregular multilayer photovoltaic panel (P) resting on the abutment base (3) and the movable rigid plane (6) in the lowered position, the irregular multilayer photovoltaic panel (P) being interposed between the movable rigid plane (6) and the supporting plane (3a) of the abutment base (3), in particular being pressed between the movable rigid plane (6) and the supporting abutment base (3);
- a feeding unit (9) for supplying at least one irregular multilayer photovoltaic panel (P) to be manufactured to the lamination chamber (2), the feeding unit (9) comprising at least one feeding shuttle (10) movable between a picking-up position (L1), wherein the feeding shuttle (10) is located outside the lamination chamber (2) to grip, by means of at least one gripping element (11), the at least one protruding portion (P2) of an irregular multilayer photovoltaic panel (P) to be supplied and a deposit position, wherein the feeding shuttle (10) is located inside the lamination chamber (2) of the membraneless laminator group (1) to release the picked-up irregular multilayer photovoltaic panel (P) on the supporting plane (3a) of the abutment base (3) of the lamination chamber (2), the deposit position being reachable by the feeding shuttle (10) of the feeding unit (9) only when the movable cover element (6) is positioned in the open position;
- a discharging unit (12) for removing at least one irregular multilayer photovoltaic panel (P) from the lamination chamber (2), the discharging unit (12) comprising a discharging shuttle (13) movable between a recovery position (L3), wherein the discharging shuttle (13) is located inside the lamination chamber (2) to grip, by means of at least one gripping element (14), the at least one protruding portion (P2) of the manufactured irregular multilayer photovoltaic panel (P) lying on the supporting plane (3a) of the abutment base (3) of the lamination chamber (2) and a deposit position (L4), wherein the discharging shuttle (13) of the discharging unit (12) is located outside the lamination chamber (2) to release the recovered irregular multilayer photovoltaic panel (P) on a corresponding deposit region of the discharging unit (12), the recovery position being reachable by the discharging shuttle (12) of the discharging unit (13) only when the movable cover element (4) is in the open position.

In a further independent aspect 1^{st} quater, which can be combined with the previous aspect and/or any one of the following aspects, a membraneless laminator group (1) for making irregular multilayer photovoltaic panels (P) of the type having at least one flat portion (P1) and at least one protruding portion (P2) developing transversally with respect to the flat portion (P1), such as a protruding frame or one or more protruding edges, comprises:
- at least one lamination chamber (2) configured to operate in vacuum, wherein the lamination chamber (2) comprises: an abutment base (3) provided with a supporting plane (3a) for supporting at least one irregular multilayer photovoltaic panel (P); a movable cover element (4) movable with respect to the abutment base (3) between an open position, wherein at least one irregular multilayer photovoltaic panel (P) can be inserted into the lamination chamber (2) or removed from the latter, and a closed position, wherein the movable cover element (4) engages the abutment base (3) by defining a sealable space (5), closed and isolated from the outside; a movable rigid plane (6) located inside the lamination chamber (2) and movable between a raised position, wherein the movable rigid plane (6) is spaced from the supporting plane (3a) of the abutment base (3) and a lowered position, wherein the movable rigid plane (6) is close to the supporting plane (3a) of the abutment base (3); in an operating condition with an irregular multilayer photovoltaic panel (P) resting on the supporting plane (3a) of the abutment base (3) and the movable rigid plane (6) in the lowered position, the irregular multilayer photovoltaic panel (P) being interposed between the movable rigid plane (6) and the supporting plane (3a) of the abutment base (3), in particular the irregular multilayer photovoltaic panel (P) being pressed between the movable rigid plane (6) and the supporting plane (3a) of the abutment base (3); at least one mould template (7) engageable or engaged to the movable rigid plane (6) so that to be located between the movable rigid plane (6) and the supporting plane (3a) of the abutment base (3) on which the irregular multilayer photovoltaic panel (P) to be manufactured is leaning on, the mould template (7) having a shape configured to adapt the movable rigid plane (6) to the irregular multilayer photovoltaic panel (P), the mould template (7) being configured to transmit a pressure force from the movable rigid plane (6) to the at least one flat portion (P1) of the irregular multilayer photovoltaic panel (P) to be manufactured when the movable rigid plane (6) is in the lowered position; optionally, a floppy adaptive element (8) engageable or engaged at least on opposite sides (6a) of the movable rigid plane (6), the mould template (7) being interposed between the movable rigid plane (6) and the floppy adaptive element (8), in the open position of the movable cover element (4) and/or in the raised position of the movable rigid plane (6), the floppy adaptive element (8) hanging from the movable rigid plane (6) towards the supporting plane (3a) of the abutment base (3) so that to define an arched configuration with a convexity (8a) facing towards the supporting plane (3a) of the abutment base (3), in the lowered position of the movable rigid plane (6) the floppy adaptive element (8) being pressed between the mould template (7) and the irregular multilayer photovoltaic panel (P) to be manufactured, defining a layer of seal which covers the at least one flat portion (P1) and, at least partially, the at least one protruding portion (P2) of the irregular multilayer photovoltaic panel (P) so as to evenly distribute the pressure forces on the latter;
- a feeding unit (9) for supplying at least one irregular multilayer photovoltaic panel (P) to be manufactured to the lamination chamber (2), the feeding unit (9) comprising at least one feeding shuttle (10) movable between a picking-up position (L1), wherein the feeding shuttle (10) of the feeding unit (9) is located outside the lamination chamber (2) to grip, by means of at least one gripping element (11), the at least one protruding portion (P2) of an irregular multilayer photovoltaic panel (P) to be supplied and a deposit position (L2), wherein the feeding shuttle (10) is located inside the lamination chamber (2) of the membraneless laminator group (1) to release the picked-up irregular multilayer photovoltaic panel (P) on the supporting plane (3a) of the abutment base (3) of the lamination chamber (2), the deposit position (L2) being reachable by the feeding shuttle (10) of the feeding unit (9) only when the movable cover element (4) is in the open position;
- a discharging unit (12) for removing at least one irregular multilayer photovoltaic panel (P) from the lamination chamber (2), the discharging unit (12) comprising a discharging shuttle (13) movable between a recovery position (L3), wherein the discharging shuttle (13) is located inside the lamination chamber (2) to grip, by means of at least one gripping element (14), the at least one protruding portion (P2) of the manufactured irregular multilayer photovoltaic panel (P) lying on the supporting plane (3a) of the abutment base (3) of the lamination chamber (2) and a deposit position (L4), wherein the discharging shuttle (13) of the discharging unit (12) being located outside the lamination chamber (2) to release the recovered irregular multilayer photovoltaic panel (P) on a corresponding deposit region of the discharging unit (12), the recovery position (L3) being reachable by the discharging shuttle (13) of the discharging unit (12) only when the movable cover element (4) is positioned in the open position.

In a further independent aspect 1^{st} quinquies, which can be combined with the previous aspects and/or any one of the following aspects, a plant (100) of manufacturing irregular multilayer photovoltaic panel (P) of the type having at least one flat portion (P1) and at least one protruding portion (P2) developing transversally with respect to the flat portion (P1), such as a protruding frame or one or more protruding edges, comprises:
- at least one arrangement station (101) wherein one or more strings of photovoltaic cells are prepared;
- at least one welding station (102) wherein one or more strings of photovoltaic cells prepared at the arrangement station (101) is/are welded with corresponding bus bars;
- at least one setting station (103) wherein a plurality of layers of each irregular multilayer photovoltaic panel (P) to be manufactured is arranged above a travelling tray in a mutually overlapping relationship, in particular, a supporting lamina (P4), optionally metallic, being arranged directly onto a corresponding travelling tray, a first encapsulating layer being arranged over the supporting lamina (P4), a backsheet layer being arranged over the first encapsulating layer, a second encapsulating layer being arranged over the backsheet layer, the strings of photovoltaic cells being arranged over the second encapsulating layer, a third encapsulating layer being arranged over the strings of photovoltaic cells and a glass layer being arranged over the third encapsulating layer;
- a membraneless laminator group (1) comprising at least one lamination chamber (2) configured to operate in vacuum, wherein the lamination chamber (2) comprises: an abutment base (3) provided with a supporting plane (3a) for supporting at least one irregular multilayer photovoltaic panel (P); a movable cover element (4) movable with respect to the abutment base (3) between an open position, wherein at least one irregular multilayer photovoltaic panel (P) can be inserted into the lamination chamber (2) or removed from the latter, and a closed position, wherein the movable cover element (4) engages the abutment base (3) by defining a sealable space (5), closed and isolated from the outside; a movable rigid plane (6) located inside the lamination chamber (2) and movable between a raised position, wherein the movable rigid plane (6) is spaced from the supporting plane (3a) of the abutment base (3) and a lowered position, wherein the movable rigid plane (6) is close to the supporting plane (3a) of the abutment base (3); in an operating condition with an irregular multilayer photovoltaic panel (P) resting on the supporting plane (3a) of the abutment base (3) and the movable rigid plane (6) in the lowered position, the irregular multilayer photovoltaic panel (P) being interposed between the movable rigid plane (6) and the supporting plane (3a) of the abutment base (3), in particular the irregular multilayer photovoltaic panel (P) being pressed between the movable rigid plane (6) and the supporting plane (3a) of the abutment base (3); at least one mould template (7) engageable or engaged to the movable rigid plane (6) so that to be located between the movable rigid plane (6) and the supporting plane (3a) of the abutment base (3) on which the irregular multilayer photovoltaic panel (P) to be manufactured is leaning on, the mould template (7) having a shape configured to adapt the movable rigid plane (6) to the irregular multilayer photovoltaic panel (P), the mould template (7) being configured to transmit a pressure force from the movable rigid plane (6) to the at least one flat portion (P1) of the irregular multilayer photovoltaic panel (P) to be manufactured when the movable rigid plane (6) is in the lowered position; optionally, a floppy adaptive element (8) engageable or engaged at least on opposite sides (6a) of the movable rigid plane (6), the mould template (7) being interposed between the movable rigid plane (6) and the floppy adaptive element (8), in the open position of the movable cover element (4) and/or in the raised position of the movable rigid plane (6), the floppy adaptive element (8) hanging from the movable rigid plane (6) towards the supporting plane (3a) of the abutment base (3) so that to define an arched configuration with a convexity (8a) facing towards the supporting plane (3a) of the abutment base (3), in the lowered position of the movable rigid plane (6) the floppy adaptive element (8) being pressed between the mould template (7) and the irregular multilayer photovoltaic panel (P) to be manufactured, defining a layer of seal which covers the at least one flat portion (P1) and, at least partially, the at least one protruding portion (P2) of the irregular multilayer photovoltaic panel (P) so as to evenly distribute the pressure forces on the latter; a feeding unit (9) for supplying at least one irregular multilayer photovoltaic panel (P) to be manufactured to the lamination chamber (2), the feeding unit (9) comprising at least one feeding shuttle (10) movable between a picking-up position (L1), wherein the feeding shuttle (10) of the feeding unit (9) is located outside the lamination chamber (2) to grip, by means of at least one gripping element (11), the at least one protruding portion (P2) of an irregular multilayer photovoltaic panel (P) to be supplied and a deposit position (L2), wherein the feeding shuttle (10) is located inside the lamination chamber (2) of the membraneless laminator group (1) to release the picked-up irregular multilayer photovoltaic panel (P) on the supporting plane (3a) of the abutment base (3) of the lamination chamber (2), the deposit position (L2) being reachable by the feeding shuttle (10) of the feeding unit (9) only when the movable cover element (4) is in the open position, at the feeding unit (9) the travelling tray being recovered from the irregular multilayer photovoltaic panel (P) to be reused again at the setting station (103) after the gripping element (11) of the feeding shuttle (10) has taken the at least one protruding portion (P2) of the irregular multilayer photovoltaic panel (P) to be supplied to the lamination chamber (2); a discharging unit (12) for removing at least one irregular multilayer photovoltaic panel (P) from the lamination chamber (2), the discharging unit (12) comprising a discharging shuttle (13) movable between a recovery position (L3), wherein the discharging shuttle (13) is located inside the lamination chamber (2) to grip, by means of at least one gripping element (14), the at least one protruding portion (P2) of the manufactured irregular multilayer photovoltaic panel (P) lying on the supporting plane (3a) of the abutment base (3) of the lamination chamber (2) and a deposit position (L4), wherein the discharging shuttle (13) of the discharging unit (12) is located outside the lamination chamber (2) to release the recovered irregular multilayer photovoltaic panel (P) on a corresponding deposit region of the discharging unit (12), the recovery position (L3) being reachable by the discharging shuttle (13) of the discharging unit (12) only when the movable cover element (4) is positioned in the open position.

In a further independent aspect 1^{st} sexies, which can be combined with the previous aspect and/or any one of the following aspects, a method of manufacturing an irregular multilayer photovoltaic panel (P) of the type having at least one flat portion (P1) and at least one protruding portion (P2) developing transversally with respect to the flat portion (P1), such as a protruding frame or one or more protruding edges, comprises the following steps:
- preparing at least one irregular multilayer photovoltaic panel (P) by placing a plurality of layers over a travelling tray in a mutually overlapping relationship, in particular the preparing step being defined by positioning a supporting lamina (P4), optionally metallic, directly onto a corresponding travelling tray and a plurality of layers, including one or more strings of photovoltaic cells, over the supporting lamina (P4), the supporting laming (P4) defining the protruding portions (P2) of the irregular multilayer photovoltaic panel (P) to be manufactured;
- supplying the prepared irregular multilayer photovoltaic panel (P) to a lamination chamber (2) of a membraneless lamination group (1) configured to operate in vacuum, wherein at the lamination chamber (2) the supplied irregular multilayer photovoltaic panel (P) to be manufactured, is subject to a deareation operation, heating operation, and pressing operation, the pressing operation being carried out by using at least one template mould 7 which presses only the corresponding flat portion (P1) of the irregular multilayer photovoltaic panel (P) avoiding the protruding portion (P2) thereof, the supplying step being anticipated by a separation step of the travelling tray which is recovered for reuse and being carried out by directly gripping the protruding portion (P2) of each irregular multilayer photovoltaic panel (P) to be manufactured;
- removing each manufactured irregular multilayer photovoltaic panel (P) from the lamination chamber (2) by directly gripping the protruding portion (P2) thereof.

In a 2^{nd} aspect according to any one of the previous aspects, the at least one mould template (7) has a flat shape.

In a 3^{rd} aspect according to any one of the previous aspects, the at least one mould template (7) has a parallelepiped shape.

In a 4^{th} aspect according to any one of the previous aspects, the at least one mould template (7) has a shape that at least in part lies within the outline of the at least one flat portion (P1) of the at least one irregular multilayer photovoltaic panel (P) to be manufactured.

In a 5^{th} aspect according to any one of the previous aspects, the at least one mould template (7) has a shape that completely lies within the outline of the at least one flat portion (P1) of the at least one irregular multilayer photovoltaic panel (P) to be manufactured.

In a 6^{th} aspect according to any one of the previous aspects, the at least one mould template (7) has a shape substantially equal to the shape of the at least one flat portion (P1) of the at least one irregular multilayer photovoltaic panel (P) to be manufactured.

In a 7^{th} aspect according to any one of the previous aspects, the at least one mould template (7) has an engaging surface faced to the supporting plane (3a) of the abutment base (3) substantially counter shaped to the at least one flat surface (P1) of the irregular multilayer photovoltaic panel (P) to be manufactured.

In a 8^{th} aspect according to any one of the previous aspects, the at least one mould template (7) has a thickness not less than the measurement of how far the at least one protruding portion (P2) projects with respect to the at least one flat portion (P1) of the at least one irregular multilayer photovoltaic panel (P) to be manufactured.

In a 9^{th} aspect according to any one of the previous aspects, the lamination chamber (2) also comprises a floppy adaptive element (8) engageable or engaged at least on opposite sides (6a) of the movable rigid plane (6).

In a 10^{th} aspect according to any one of the previous aspects, the lamination chamber (2) comprises a floppy adaptive element (8) engageable or engaged at least on two perimetric portions of the movable rigid plane (6).

In an 11^{th} aspect according to any one of the previous two aspects, in the open position of the movable cover element (4) and/or in the raised position of the movable rigid plane (6), the floppy adaptive element (8) hangs from the movable rigid plane (6) towards the supporting plane (3a) of the abutment base (3) so that to define an arched configuration with a convexity (8a) facing towards the supporting plane (3a) of the abutment base (3).

In a 12^{th} aspect according to any one of the previous three aspects, in the open position of the movable cover element (4) and/or in the raised position of the movable rigid plane (6), the floppy adaptive element (8) hangs from the movable rigid plane (6) towards the supporting plane (3a) of the abutment base (3) so that to define a concavity space (8b) between the at least one mould template (7) and the floppy adaptive element (8).

In a 13^{th} aspect according to any one of the previous four aspects, the floppy adaptive element (8) is made of a flexible material.

In a 14^{th} aspect according to any one of the previous five aspects, the floppy adaptive element (8) is made of a deformable material.

In a 15^{th} aspect according to any one of the previous six aspects, the floppy adaptive element (8) is made in the shape of a carpet or a belt or a tape.

In a 16^{th} aspect according to any one of the previous seven aspects, the floppy adaptive element (8) is made of a plastic material.

In a 17^{th} aspect according to any one of the previous eight aspects, the floppy adaptive element (8) is made of a plastic material resistant to high temperatures, in particular resistant to a temperature comprised between 100° C and 400° C, optionally comprised between 110° C and 350° C, in particular comprised between 120° C and 300° C, more in particular comprised between 140° C and 250° C.

In a 18^{th} aspect according to any one of the previous nine aspects, the floppy adaptive element (8) is made of a plastic material with a high anti-adhesion capacity.

In a 19^{th} aspect according to any one of the previous ten aspects, the floppy adaptive element (8) is made of polytetrafluoroethylene.

In a 20^{th} aspect according to any one of the previous eleven aspects, the floppy adaptive element (8) is made of silicone resistant to high temperatures, in particular resistant to a temperature comprised between 100° C and 400° C, optionally comprised between 110° C and 350° C, in particular comprised between 120° C and 300° C, more in particular comprised between 140° C and 250° C.

In a 21^{st} aspect according to any one of the previous twelve aspects, the at least one mould template (7) is interposed between the movable rigid plane (6) and the floppy adaptive element (8).

In a 22^{nd} aspect according to any one of the previous thirteen aspects, in the lowered position of the movable rigid plane (6), the floppy adaptive element (8) is pressed between the at least one mould template (7) and the at least one irregular multilayer photovoltaic panel (P) to be manufactured lying on the supporting plane (3a) of the abutment base (3), the pressed floppy adaptive element (8) defining a layer of seal covering completely the at least one flat portion (P1) and, at least partially, the at least one protruding portion (P2) of the irregular multilayer photovoltaic panel (P).

In a 23^{rd} aspect according to any one of the previous fourteen aspects, the mould template (7) can be substituted with a different mould template (7) suitable for manufacturing at least one irregular multilayer photovoltaic panel (P) having one or more flat portions (P1) and one or more protruding portions (P2) different with respect to the flat and protruding portions (P1, P2) of the at least one irregular multilayer photovoltaic panel (P) which is being manufactured.

In a 24^{th} aspect according to any one of the previous aspects, the supporting plane (3a) of the abutment base (3) the lamination chamber (2) is provided with at least one groove (15a) for accommodating at least one projection portion (P3) of the at least one irregular multilayer photovoltaic panel (P) transversally developing with respect the flat portion (P1) on the opposite side of the protruding portion (P2), the groove (15a) allowing the at least one irregular multilayer photovoltaic panel (P) to lie on the supporting plane (2) of the abutment base (3) parallel to the latter.

In a 25^{th} aspect according to the previous aspect, the supporting plane (3a) of the abutment base (3) of the lamination chamber (2) can be substituted with a different supporting plane (3a) for manufacturing at least one irregular multilayer photovoltaic panel (P) having one or more flat portions (P1) and one or more projecting portions (P3) different with respect to the ones of the at least one irregular multilayer photovoltaic panel (P) which is being manufactured.

In a 26^{th} aspect according to any one of the previous aspects, the supporting plane (3a) of the abutment base (3) is provided with a supporting mould template (15) provided with at least one groove (15a) for accommodating at least one projection portion (P3) of the at least one irregular multilayer photovoltaic panel (P) transversally developing with respect to the flat portion (P1) on the opposite side of the protruding portion (P2), the groove (15a) allowing the at least one irregular multilayer photovoltaic panel (P) to lie on the supporting plane (3a) of the abutment base (3) parallel to the supporting plane (3a).

In a 27^{th} aspect according to the previous aspect, the supporting mould template (15) can be substituted with a different supporting mould template (15) for manufacturing at least one irregular multilayer photovoltaic panel (P) having one or more flat portions (P1) and one or more projecting portions (P3) different with respect to the ones of the at least one irregular multilayer photovoltaic panel (P) which is being manufactured.

In a 28^{th} aspect according to any one of the four previous aspects, the supporting mould template (15) or the supporting plane (3a) of the abutment base (3) comprises a plurality of grooves (15a) for accommodating at least one projection portion (P3) of the at least one irregular multilayer photovoltaic panel (P) transversally developing with respect to the flat portion (P1) on the opposite side of the protruding portion (P2), the grooves (15a) allowing the support of different irregular multilayer photovoltaic panels (P) having different configurations in relation to the projection portions (P3), each groove (15a) being coverable by the application of a corresponding closure plate in order to set up the supporting mould template (15) or the supporting plane (3a) of the abutment base (2) to the configuration of the projection portions (P3) of the irregular multilayer photovoltaic panel (P) to be manufactured.

In a 29^{th} aspect according to any one of the previous aspects, the membraneless laminator group (1) comprises a feeding unit (9) for supplying at least one irregular multilayer photovoltaic panel (P) to be manufactured to the lamination chamber (2), the feeding unit (9) comprising at least one feeding shuttle (10) movable between a picking-up position (L1), wherein the feeding shuttle (10) is located outside the lamination chamber (2) to grip the at least one protruding portion (P2) of an irregular multilayer photovoltaic panel (P) to be supplied and a deposit position (L2), wherein the feeding shuttle (10) is located inside the lamination chamber (2) of the membraneless laminator group (1) to release the picked-up irregular multilayer photovoltaic panel (P) on the supporting plane (3a) of the abutment base (3) of the lamination chamber (2), the deposit position being reachable by the feeding shuttle (10) of the feeding unit (9) only when the movable cover element (4) is positioned in the open position.

In a 30^{th} aspect according to the previous aspect, the feeding unit (9) comprises at least one gripping element (11) operatively connected to the feeding shuttle (10), in particular two or more gripping elements (11) or a plurality of gripping elements (11), each operable between a spread condition, wherein the gripping element (11) does not grip anything, and a tight condition, wherein the gripping element (11) grips the at least one protruding portion (P2) of a corresponding irregular multilayer photovoltaic panel (P).

In a 31^{st} aspect according to any one of the two previous aspects, the feeding shuttle (10) of the feeding unit (9) comprises:
- a sliding structure (16) slidable between the picking-up position (L1) and the deposit position (L2);
- a supporting structure (17) operatively engaged to the sliding structure (16) which supports the at least one gripping element (11), optionally each gripping element (11), the supporting structure (17) being movable between a raised position, wherein the sliding structure (16) of the feeding shuttle (10) can be moved between the picking-up position (L1) and the deposit position with or without an irregular multilayer photovoltaic panel (P) gripped by the gripping element (11) and a lowered position, wherein the sliding structure (16) is held steady to allow an operation of picking-up an irregular multilayer photovoltaic panel (P) or an operation of dropping an irregular multilayer photovoltaic panel (P).

In a 32^{nd} aspect according to the previous aspect, the sliding structure (16) of the feeding shuttle (10) of the feeding unit (9) is driven by an electric motor (18), in particular, a brushless electric motor.

In a 33^{rd} aspect according to any one of the two previous aspects, the sliding structure (16) of the feeding shuttle (10) of the feeding unit (9) is slidable along at least one sliding track (19), optionally a couple of parallel sliding tracks (19), developing at least between the feeding unit (9) and the lamination chamber (2), in particular the sliding structure (16) engaging the at least one sliding track (19) by means of at least one corresponding slider or a carriage.

In a 34^{th} aspect according to the aspect 32^{nd} or the aspect 33^{rd} when depending on the 32^{nd} aspect, the feeding unit (9) comprises at least one transmission mechanism (20) operable between the feeding shuttle (10) and the corresponding electric motor (18), the transmission mechanism (20) moving the feeding shuttle (10) between the picking-up position (L1) and the deposit position (L2) on electric motor (18) control.

In a 35^{th} aspect according to the previous aspect, the transmission mechanism (20) comprises at least one transmission belt (21) developing along the at least one sliding track (19) between two end transmission pulleys (22) operatively located on such a sliding track (19), optionally one end transmission pulley (22) being located close to the picking-up position (L1) and the other end transmission pulley (22) being located close to the deposit position (L2), the transmission belt (21) partially developing around each end transmission pulley (22) so that one forward branch and a return branch are defined on the transmission belt (21) between the end transmission pulleys (22).

In a 36^{th} aspect according to the previous aspect, the transmission belt (21) also partially develops around a drive pulley (23) operatively located on the corresponding sliding track (19), in particular the return branch of the transmission belt (21) partially developing around the drive pulley (23), the drive pulley (23) being connected to the corresponding electric motor (18) to be activated by the latter when triggered.

In a 37^{th} aspect according to any one of the previous two aspects, the sliding structure (16) of the feeding shuttle (10) of the feeding unit (9) is engaged, optionally fixed, to the transmission belt (21) of the corresponding transmission mechanism (20) to be dragged into motion by the transmission belt (21) along the corresponding sliding track (19) between the picking-up position (L1) and the deposit position (L2).

In a 38^{th} aspect according to the previous aspect, the sliding structure (16) of the feeding shuttle (10) of the feeding unit (9) engages the transmission belt (21) of the corresponding transmission mechanism (20) by at least one corresponding fastening device (24), the fastening device (24) being openable and/or loosable to disengage the feeding shuttle (10) from the corresponding transmission belt (21).

In a 39^{th} aspect according to any one of the previous aspects, the feeding unit (9) comprises a transmission mechanism (20) for each sliding track (19) provided, each transmission mechanism (20) presenting a corresponding transmission belt (21), corresponding end pulleys (22) and a corresponding drive pulley (23), the electric motor (18) being able to trigger both the transmission mechanisms (20) by a corresponding transmission rod (25) mechanically connected to the drive pulley (23) of each transmission mechanism (20).

In a 40^{th} aspect according to any one of the previous aspects, the membraneless laminator group (1) comprises a discharging unit (12) for removing at least one irregular multilayer photovoltaic panel (P) from the lamination chamber (2), the discharging unit (12) comprising a discharging shuttle (13) movable between a recovery position (L3), wherein the discharging shuttle (13) is located inside the lamination chamber (2) to grip the at least one protruding portion (P2) of the manufactured irregular multilayer photovoltaic panel (P) lying on the supporting plane (3a) of the abutment base (3) of the lamination chamber (2) and a deposit position (L4), wherein the discharging shuttle (13) is located outside the lamination chamber (2) to release the recovered irregular multilayer photovoltaic panel (P) on a corresponding deposit region of the discharging unit (12), the recovery position (L3) being reachable by the discharging shuttle (13) of the discharging unit (12) only when the movable cover element (4) is positioned in the open position.

In a 41^{st} aspect according to the previous aspect, the discharging unit (12) comprises at least one gripping element (14) operatively connected to the discharging shuttle (13), in particular two or more gripping elements (14) or a plurality of gripping elements (14), each operable between a spread condition, wherein the gripping element (14) does not grip anything, and a tight condition, wherein the gripping element (14) grips the at least one protruding portion (P2) of a corresponding irregular multilayer photovoltaic panel (P).

In a 42^{nd} aspect according to any one of the two previous aspects, the discharging shuttle (13) of the discharging unit (12) comprises:
- a sliding structure (26) slidable between the recovery position (L3) and the deposit position (L4);
- a supporting structure (27) operatively engaged to the sliding structure (26) and supporting the gripping element (14), optionally each gripping element (14), the supporting structure (27) being movable between a raised position, wherein the sliding structure (26) of the discharging shuttle (13) can be moved between the recovery position (L3) and the deposit position (L4) with or without an irregular multilayer photovoltaic panel (P) gripped by the gripping element (14) and a lowered position, wherein the sliding structure (26) is held steady to allow an operation of picking-up an irregular multilayer photovoltaic panel (P) or an operation of dropping an irregular multilayer photovoltaic panel (P).

In a 43^{rd} aspect according to the previous aspect, the sliding structure (26) of the discharging shuttle (13) of the discharging unit (12) is driven by an electric motor (28), in particular, a brushless electric motor.

In a 44^{th} aspect according to any one of the two previous aspects, the sliding structure (26) of the discharging shuttle (13) of the discharging unit (12) is slidable along at least one sliding track (29), optionally a couple of parallel sliding tracks (29), developing at least between the discharging unit (12) and the lamination chamber (2), in particular the sliding structure (26) engaging the at least one sliding track (29) by means of at least one slider and/or a carriage.

In a 45^{th} aspect according to the aspect 43^{rd} or the aspect 44^{th} when depending on the aspect 43^{rd}, the discharging unit (12) comprises at le-ast one transmission mechanism (30) operable between the discharging shuttle (13) and the corresponding electric motor (28), the transmission mechanism (30) moving the feeding shuttle (13) between the recovery position (L3) and the deposit position (L4) on electric motor (28) control.

In a 46^{th} aspect according to the previous aspect, the transmission mechanism (30) comprises at least one transmission belt (31) developing along the at least one sliding track (29) between two end transmission pulleys (32) operatively located on such a sliding track (29), optionally one end transmission pulley (32) being located close to the recovery position (L3) and the other end transmission pulley (32) being located close to the deposit position (L4), the transmission belt (31) partially developing around each end transmission pulley (32) so that one forward branch and a return branch are defined on the transmission belt (31) between the end transmission pulleys (32).

In a 47^{th} aspect according to the previous aspect, the transmission belt (31) also partially develops around a drive pulley (33) operatively located on the corresponding sliding track (29), in particular the return branch of the transmission belt (31) partially developing around the drive pulley (33), the drive pulley (33) being connected to the corresponding electric motor (28) to be activated by the latter when triggered.

In a 48^{th} aspect according to any one of the previous two aspects, the sliding structure (26) of the discharging shuttle (13) of the discharging unit (12) is engaged, optionally fixed, to the transmission belt (31) of the corresponding transmission mechanism (30) to be dragged into motion by the transmission belt (31) along the corresponding sliding track (29) between the recovery position (L3) and the deposit position (L4).

In a 49^{th} aspect according to the previous aspect, the sliding structure (26) of the discharging shuttle (13) of the discharging unit (12) engages the transmission belt (31) of the corresponding transmission mechanism (30) by at least one corresponding fastening device (34), the fastening device (34) being openable and/or loosable to disengage the discharging shuttle (13) from the corresponding transmission belt (31).

In a 50^{th} aspect according to any one of the five previous aspects, the discharging unit (12) comprises a transmission mechanism (30) for each sliding track (29) provided, each transmission mechanism (30) presenting a corresponding transmission belt (31), corresponding end transmission pulleys (32) and a corresponding drive pulley (33), the electric motor (28) being able to trigger both the transmission mechanisms (30) by a corresponding transmission rod (35) mechanically connected to the drive pulley (33) of each transmission mechanism (30).

In a 51^{st} aspect according any one of the seven previous aspects, the sliding track (19, 29), optionally the couple of parallel sliding tracks (19, 29), of the feeding unit (9) and the discharging unit (12) define a single sliding track or a single couple of sliding tracks developing between the feeding unit (9) and the discharging unit (12), passing close to or at a respective side of the lamination chamber (2).

In a 52^{nd} aspect according to any one of the twelve previous aspects, the deposit position (L2) of the feeding shuttle (10) of the feeding unit (9) is substantially the same position as the recovery position (L3) of the discharging shuttle (13) of the discharging unit (12), when the feeding shuttle (10) of the feeding unit (9) is located in the deposit position (L1) inside the lamination chamber (2), the discharging shuttle (13) of the discharging unit (12) is located in the deposit position (L4) outside the lamination chamber (2), vice versa when the discharging shuttle (13) of the discharging unit (10) is located in the recovery position (L3) inside the lamination chamber (2), the feeding shuttle (10) of the feeding unit (9) is located in the picking-up position (L1) outside the lamination chamber (2).

In a 53^{rd} aspect according to any one of the previous aspects, the movable rigid plane (6) of the lamination chamber (2) is heatable.

In a 54^{th} aspect according to any one of the previous aspects, the movable rigid plane (6) of the lamination chamber (2) includes at least one heating device which is activable for heating the movable rigid plane (6) and heating by conduction the mould template (7).

In a 55^{th} aspect according to the previous aspect, the heating device () of the movable rigid plane (6) of the lamination chamber (2) is integrated, in particular, embedded, in the body of the movable rigid plane (6).

In a 56^{th} aspect according to any one of the previous aspects, the supporting plane (3a) of the abutment base (3) of the lamination chamber (2) is heatable.

In a 57^{th} aspect according to any one of the previous aspects, the supporting plane (3a) of the abutment base (3) of the lamination chamber (2) includes at least one auxiliary heating device which is activable for heating the supporting plane (3a).

In a 58^{th} aspect according to the previous aspect, the auxiliary heating device of the supporting plane (3a) of the abutment base (3) of the lamination chamber (2) is integrated, in particular, embedded, into the body of the supporting plane (3a).

In a 59^{th} aspect according to any one of the previous aspects, the lamination chamber (2) comprises at least one control mechanism (35) operatively connected to the movable rigid plane (6) to move the latter between the raised position and the lowered position.

In a 60^{th} aspect according to the previous aspect, the control mechanism (35) comprises at least one dynamic fluid actuator (35a), in particular a dynamic fluid cylinder and/or piston, connected to, optionally mechanically connected to the movable rigid plane (6) of the lamination chamber (2), to move the latter between the raised position and the lowered position and, in particular, to press, in the lowered position of the movable rigid plane (6), an irregular multilayer photovoltaic panel (P) lying on the supporting plane (3a) of the abutment base (3) of the lamination chamber (2).

In a 61^{st} aspect according to the two previous aspects, the control mechanism (35) comprises a plurality of dynamic fluid actuators (35a), in particular a plurality of dynamic fluid cylinders and/or pistons, each connected to, optionally mechanically connected to, the movable rigid plane (6) of the lamination chamber (2), to move the latter between the raised position and the lowered position and, in particular, to press, in the lowered position of the movable rigid plane (6), an irregular multilayer photovoltaic panel (P) lying on the supporting plane (3a) of the abutment base (3) of the lamination chamber (2).

In a 62^{nd} aspect according to the two previous aspects, the dynamic fluid cylinder and/or piston of each dynamic fluid actuator (35a) of the control mechanism (35) is located on and/or at the movable cover element (4) of the lamination chamber (2) and connected to the movable rigid plane (6) by a corresponding airtight through opening (40).

In a 63^{rd} aspect according to the three previous aspects, the lamination chamber (2) comprises at least one compression mechanism (36) operatively active on the movable rigid plane (6) to press the latter towards the supporting plane (3a) of the abutment base (3) when the movable rigid plane (6) is positioned in the lowered position. In a 64^{th} aspect according to the previous aspect, the compression mechanism (36) comprises a plurality of dynamic fluid actuators (36a), in particular a plurality of dynamic fluid cylinders and/or pistons, each adapted to operate on the movable rigid plane (6) of the lamination chamber (2) to press the latter, in the lowered position of the movable rigid plane (6), against an irregular multilayer photovoltaic panel (P) lying on the supporting plane (3a) of the abutment base (3) of the lamination chamber (2).

In a 65^{th} aspect according to the two previous aspects, the dynamic fluid cylinder and/or piston of each dynamic fluid actuator (36a) of the compression mechanism (36) is located on and/or at the movable cover element (4) of the lamination chamber (2) and is able to operate on the movable rigid plane (6) by a corresponding airtight through opening (41).

In a 66^{th} aspect according to any one of the previous aspects, the lamination chamber (2) comprises at least one thermal expansion compensation mechanism (37) configured to adjust at least the relative positions between the movable cover element (4) and the movable rigid plane (6) and/or to adjust at least the relative positions between the movable cover element (4) and an external handling device (38) for moving the movable cover element (4) between the open position and the closed position, the thermal expansion compensation mechanism (37) being triggered by the thermal expansion of the elements, parts, components or members of the lamination chamber (2), that occurs during the heating of the lamination chamber (2).

In a 67^{th} aspect according to the previous aspect, the thermal expansion compensation mechanism (37) comprises a plurality of external thermal expansion compensation devices (37a) each operatively interposed between the movable cover element (4) and a corresponding handling actuator (38a) of the external handling device (38) of the lamination chamber (2).

In a 68^{th} aspect according to any one of the previous two aspects, the thermal expansion compensation mechanism (37) comprises four external thermal expansion compensation devices (37a) each operatively located in correspondence of or in proximity of a corresponding corner (4a) of the movable cover element (4) and each operatively interposed between the movable cover element (4) and a corresponding handling actuator (38a) of the external handling device (38) of the lamination chamber (2).

In a 69^{th} aspect according to any one of the previous two aspects, each external thermal expansion compensation device (37a) is configured to compensate the thermal expansions of the lamination chamber (2) at least along a compensation direction inclined with respect to orthogonal axis (X, Y) of a horizontal reference plane, in particular each external thermal expansion compensation device (37a) being configured to compensate the thermal expansions of the lamination chamber (2) at least along a compensation direction inclined with respect to a travelling direction of each irregular multilayer photovoltaic panel (P) to be manufactured and/or already manufactured, the compensation direction defined by each external thermal expansion compensation device (37a) allowing a corresponding relative movement between the movable cover element (4) and the corresponding handling actuator (38a) of the external handling device (38) of the lamination chamber (2).

In a 70^{th} aspect according to any one of the previous four aspects, the thermal expansion compensation mechanism (37) comprises a plurality of inner thermal expansion compensation devices (37b) each operatively interposed between the movable cover element (4) and the movable rigid plane (6) of the lamination chamber (2).

In a 71^{st} aspect according to any one of the previous five aspects, the thermal expansion compensation mechanism (37) comprises four inner thermal expansion compensation devices (37b) each operatively located in correspondence of or in proximity of the movable rigid plane (6).

In a 72^{nd} aspect according to any one of the previous two aspects when the 76^{th} aspects depends on the 70^{th} aspect or any one of the aspects from the 71^{st} aspect to the 75^{th} aspect, each inner thermal expansion compensation device (37b) is operatively interposed between the movable rigid plane (6) of the lamination chamber (2) and a corresponding dynamic fluid cylinder and/or piston of the dynamic fluid actuator (35a) of the control mechanism (35) of the lamination chamber (2).

In a 73^{rd} aspect according to any one of the previous three aspects, each inner thermal expansion compensation device (37b) is configured to compensate the thermal expansions of the lamination chamber (2) at least along a compensation direction inclined with respect to orthogonal axis (X, Y) of a horizontal reference plane, in particular each inner thermal expansion compensation device (37b) being configured to compensate the thermal expansions of the lamination chamber (2) at least along a compensation direction inclined with respect to a travelling direction (Z) of each irregular multilayer photovoltaic panel (P) to be manufactured and/or already manufactured, the compensation direction defined by each inner thermal expansion compensation device (37b) allowing a corresponding relative movement between the movable cover element (4) and the movable rigid plane (6).

### BRIEF DESCRIPTION OF THE DRAWINGS

The invention will be described with a reference to the annexed figures. A brief description of the figures is hereinafter presented:
- Figure 1 illustrates a perspective view of an irregular multilayer photovoltaic panel of the type to be produced by a membranless laminator group and/or a relative plant of manufacturing and/or a relative method of manufacturing, according to the present disclosure;
- Figure 2 illustrates an elevation view of a transversal cross-section of the irregular multilayer photovoltaic panel carried out along the tract II-II of Figure 1;
- Figure 3 illustrates an elevation view of two details of the transversal cross-section of the irregular multilayer photovoltaic panel properly circled in Figure 2;
- Figure 4 further illustrates a side elevation view of a detail of the irregular multilayer photovoltaic panel confined to the region circled in Figure 1;
- Figure 5 illustrates a perspective view of a membranless laminator group for making irregular multilayer photovoltaic panels of the type of shown in Figures 1 to 4, according to the present disclosure;
- Figure 6 illustrates a top view of the membranless laminator group shown in Figure 5;
- Figure 7 illustrates an elevation view of a transversal cross-section of the membranless laminator group shown in Figures 5 and 6, carried out along the tract VIII-VIII of figure 7 and in an open position;
- Figure 8 illustrates an elevation view of a transversal cross-section of the membranless laminator group shown in Figures 5 and 6, carried out along the same tract of the cross-section shown in Figure 8, in a closed position;
- Figure 9 illustrates an enlarged view of a detail of the membranless laminator group shown in Figure 5;
- Figure 10 illustrates an enlarged view of the detail shown in Figure 10 wherein an element of the membranless laminator group is removed to allow a better viewing of another element;
- Figure 11 illustrates a further enlarged view of a detail of the membraneless laminator group shown in Figure 5 deprived of a structural element for viewing such a detail;
- Figure 12 illustrates a perspective view of a feeding unit of the membraneless laminator group shown in Figures 5 to 7;
- Figure 13 illustrates a further perspective view, partially interrupted, of the feeding unit of the membraneless laminator group shown in Figures 5 and 6;
- Figure 14 illustrates a perspective view of a discharging unit of the membraneless laminator group shown in Figures 5 and 6, deprived of an element, namely a cooling system;
- Figure 15 illustrates a perspective view of the discharging unit shown in Figures 5 and 6, added with a cooling system;
- Figure 16 schematically illustrates a layout of a plant of manufacturing of irregular multilayer photovoltaic panels of type of the one shown in Figures 1 to 4, provided with at least one membranless laminator group as shown in Figures 5 to 15.

### DETAILED DESCRIPTION

Before disclosing the membranless laminator group 1 and/or a corresponding plant 100 or method of manufacturing irregular multilayer photovoltaic panels P, it is necessary to define and disclosed which parts and/or elements constitute such irregular multilayer photovoltaic panels P.

The term or expression "irregular multilayer photovoltaic panel" is intended as referring to a multilayer photovoltaic panel P provided with at least one flat portion P1 and one or more protruding portions P2 which develop transversally with respect to the flat portion P1.

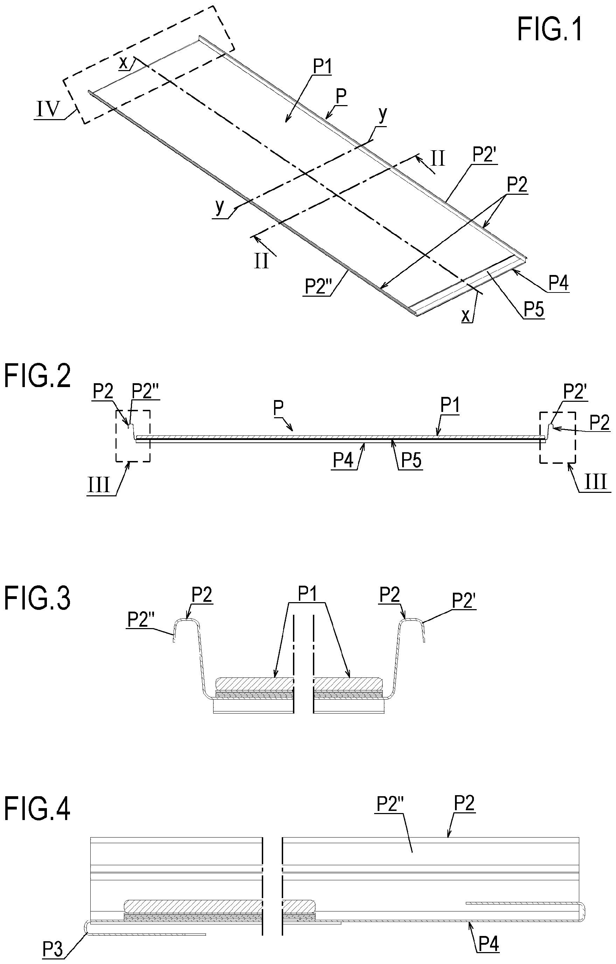

Considering Figures 1 to 4, an irregular multilayer photovoltaic panel P is shown. The irregular multilayer photovoltaic panel P comprises one flat portion P1 which is formed by different layers properly superimposed to define a flat multilayer photovoltaic body which is fixed on a central flat portion P5 of a supporting lamina P4.

The supporting lamina P4 defines the protruding portions P2 of the irregular multilayer photovoltaic panel P and also at least one projection portion P3 of such panel P.

In particular, the supporting lamina P4 is provided with two protruding portions P2', P2" significantly projecting transversally from corresponding sides and/or the corresponding parts of the central flat portion P5 of the supporting lamina 4. As can be seen in Figures 2 and 3, a first protruding portion P2' develops along a corresponding long side of the supporting lamina P4 transversally with respect to the flat portion P5 of the latter and towards a direction to which the photovoltaic body of the irregular multilayer photovoltaic panel P is pointing, namely from side facing the sun when the panel is installed on a roof of a house or a building or on a proper supporting structure of a supporting frame. A second protruding portion P2" develops along another corresponding long side of the supporting lamina P4, opposite to the one from which the first protruding portion P2' develops. In detail, the second protruding portion P2" develops transversally with respect to the flat portion P5 of the supporting lamina P4 towards the same direction of development of the first protruding portion P2'.

With a particular reference to Figure 4, a projection portion P3 develops along a corresponding short edge of the supporting lamina P4 towards a direction opposite to the direction of the first and the second protruding portions P2', P2", namely from the side of the panel arranged to face to the roof of a house or a building or to a supporting structure of a proper supporting frame. The projection portion P3 develops from the corresponding short edge of the supporting lamina 4 at least partially transversally with respect to the flat portion P5 of the latter and at least partially parallel to such a flat portion P5, defining a sort of flattened "L" shaped body.

It should be noted that, the irregular multilayer photovoltaic panel P shown in Figures 1 to 4, is an example of the irregular multilayer photovoltaic panels existing. Other irregular multilayer photovoltaic panels P can differ from the one shown in Figures 1 to 4, providing protruding portions and/or projection portion different in shape, development direction and number as well as different configurations of flat portions which can be also alternated with the other corresponding protruding portions and/or projection portions. Thus, any irregular multilayer photovoltaic panel P can be considered as long as it has one or more flat portions P1 and one or more protruding portions P2 as the ones disclosed above.

The supporting lamina P4 can be manufactured of a press-folded metallic.

Irrespective of the number and the configuration of the protruding portions P2 of the irregular multilayer photovoltaic panel P to be manufactured, the protruding portions P2 and/or the projection portions P3 are shaped and configured to allow interlocking between adjacent panels P during a traditional installation procedure by the installation and start-up personnel for photovoltaic systems.

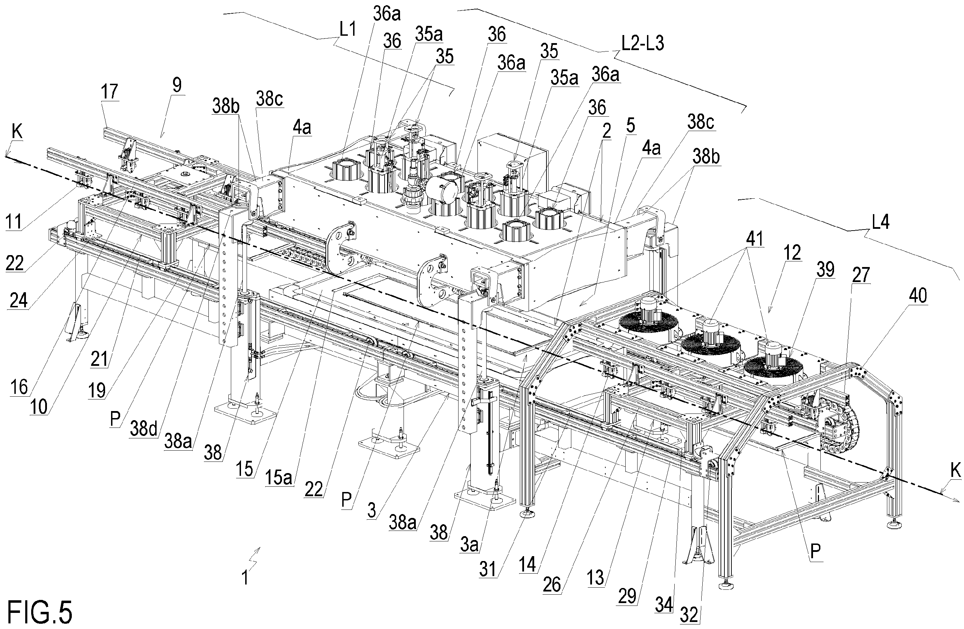

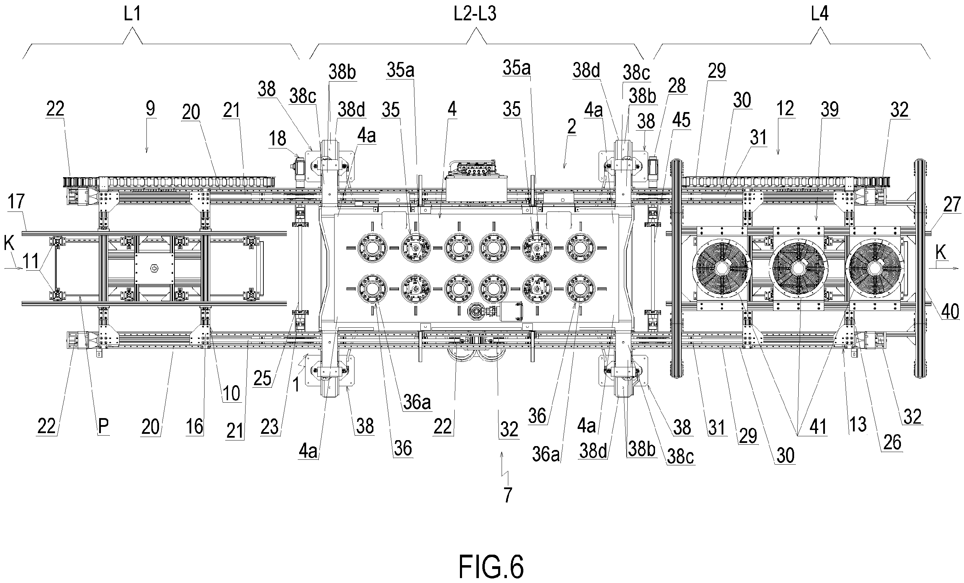

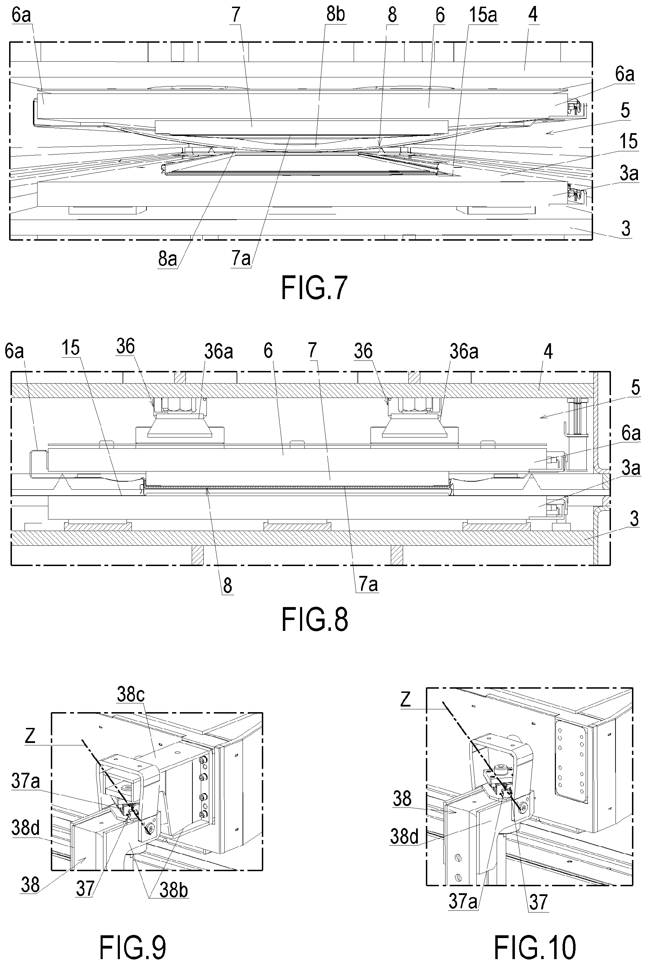

Figures 5 and 6 show a membranless laminator group 1 for making irregular multilayer photovoltaic panels P as the one disclosed above. The membraneless laminator group 1 comprises at least one lamination chamber 2 configured to operate in vacuum, which includes an abutment base 3 provided with a supporting plane 3a for supporting at least one irregular multilayer photovoltaic panel P and a movable cover element 4, movable with respect to the abutment base 3 between an open position (Figures 5 and 7), wherein at least one irregular multilayer photovoltaic panel P can be inserted into the lamination chamber 2 or removed from the latter, and a closed position (Figure 8), wherein the movable cover element 4 engages the abutment base 3 by defining a sealable space 5, closed and isolated from outside.

As can be seen in Figures 7 and 8, the lamination chamber 2 comprises a movable rigid plane 6 located inside sealable space 5. The movable rigid plane 6 is movable between a raised position (Figure 7), wherein the movable rigid plane 6 is spaced from supporting plane 3a of the abutment base 3 and a lowered position (Figure 8), wherein the movable rigid plane 6 is close to the supporting plane 3a of the abutment base 3. In an operating condition with an irregular multilayer photovoltaic panel P to be manufactured resting on the supporting plane 3a of the abutment base 3, as shown in figures 5 and 7, and the movable rigid plane 6 positioned in the lowered position (Figure 8), the irregular multilayer photovoltaic panel P is interposed between the movable rigid plane 6 and the supporting plane 3a of the abutment base 3. In this condition, the irregular multilayer photovoltaic panel P is pressed between the movable rigid plane 6 and the supporting plane 3a of the abutment base 3.

In order to enable the movable rigid plane 6 to apply a localized pressure force on the flat portion P1 of the irregular multilayer photovoltaic panel P, the lamination chamber 2 comprises at least one mould template 7 engageable or engaged below the movable rigid plane 6 so that to be located between the movable rigid plane 6 and the supporting plane 3a of the abutment base 3 on which the irregular multilayer photovoltaic panel P to be manufactured is leaning on. In other words, the mould template 7 has a shape configured to adapt the movable rigid plane 6 to the flat portion P1 of the irregular multilayer photovoltaic panel P to be manufactured. When the movable rigid plane 6 is positioned in the lowered position (Figure 8), the mould template 7 transmits a pressure force from the movable rigid plane 6 to the flat portion P1 of the irregular multilayer photovoltaic panel P.

In particular, the mould template 7 which is engaged under the movable rigid plane 6 has a flat shape, optionally a parallelepiped shape, more optionally a shape that at least in part lies within the outline of the flat portion P1 of the irregular multilayer photovoltaic panel P to be manufactured, in particular a shape that completely lies within the outline of the relative flat portion P1 of the irregular multilayer photovoltaic panel P to be manufactured.

According to an alternative embodiment of the mould template 7, it has a shape substantially equal to the shape of the respective flat portion P1 of the irregular multilayer photovoltaic panel P to be manufactured.

Considering the example of the irregular multilayer photovoltaic panels P which can be seen in figures 1, 5, 6 and 13, each corresponding flat portion P1 has a rectangular outline whereby the mould template 7 which is engaged under the movable rigid plane 6 is rectangular shaped with the same length and width dimensions of the flat portion P1 of any irregular multilayer photovoltaic panel P to be manufactured. In other words, the mould template 7 has an engaging surface 7a faced to the supporting plane 3a of the abutment base 3 substantially counter shaped to the flat surface P1 of the irregular multilayer photovoltaic panel P to be manufactured.

Furthermore, the mould template 7 has a thickness not less than the measurement of how far each protruding portion P2', P2" projects with respect to the flat portion P1 of the irregular multilayer photovoltaic panel P to be manufactured. Advantageously, the mould template 7 can be substituted with a different mould template 7 or with a plurality of mould templates 7 suitable for manufacturing an irregular multilayer photovoltaic panel P or an irregular multilayer photovoltaic assembly (not shown) having one or more flat portions P1 and one or more protruding portions P2 different with respect to the ones of the irregular multilayer photovoltaic panel P or the irregular multilayer photovoltaic assembly which is being manufactured.

In order to allow interchangeability of different versions of mould templates 7 under the movable rigid plane 6, the latter is provided with suitable coupling devices (not shown) which allow the mould templates 7 to be fixed to, or removed from, the movable rigid plane 6. The arrangement of a movable rigid plane 6 with different mould templates 7 interchangeable in relation to different sizes or different shapes or different configurations of irregular multilayer photovoltaic panels P or irregular multilayer photovoltaic assemblies to be manufactured, makes the membranless laminator group 1 and also any plant of manufacturing 100 provided with such a membranless laminator group 1, universal and universally suitable for the production of a wide range of panels P or assemblies.

When an irregular multilayer photovoltaic panel P or an irregular multilayer photovoltaic assembly to be manufactured is different in shape, sizes and/or configuration of the flat portions P1 and the protruding and/or projection portions P2, P3, with respect to the panel or assembly which in being manufactured, it is sufficient to change the mould template 7 currently in use with another one adapted to fit against the new panel or assembly to be produced.

As shown in Figures 8 and 9, a floppy adaptive element 8 is engaged on opposite sides 6a or on two perimetric portions of the movable rigid plane 6 so that the mould template 7 is interposed between the movable rigid plane 6 and the floppy adaptive element 8. The floppy adaptive element 8 is made of a plastic flexible and/or a deformable material and is made in the shape of a carpet or a belt or a tape. In particular, the floppy adaptive element 8 is made of a plastic material with a high anti-adhesion capacity and high heat resistance.

In the open position of the movable cover element 4 and/or in the raised position of the movable rigid plane 6 (Figure 7), the floppy adaptive element 8 hangs from the movable rigid plane 6 towards the supporting plane 3a of the abutment base 3 so that to define an arched configuration with a convexity 8a facing towards the supporting plane 3 of the abutment base 3. In the closed position of the movable cover element 4 and/or in the lowered position of the movable rigid plane 6, the floppy adaptive element 8 is pressed between the mould template 7 and the irregular multilayer photovoltaic panel P to be manufactured, by defining a layer of seal which covers the at flat portion P1 and, at least partially, the protruding portions P2', P2" of the irregular multilayer photovoltaic panel P so as to evenly distribute the pressure forces on the flat portion P1 of the irregular multilayer photovoltaic panel P.

Since, as already described above and shown in Figure 4, the irregular multilayer photovoltaic panel P is also provided with at least one projection portion P3 the supporting plane 3a of the abutment base 3 of the lamination chamber 2 is provided with at least one groove 15a for accommodating such a projection portion P3 so as to maintain the irregular multilayer photovoltaic panel P horizontally supported on the supporting plane 3a. In particular, the groove 15a allows the irregular multilayer photovoltaic panel P to lie on the supporting plane 2 substantially parallel to the latter and to the movable rigid plane 6 and/or the mould template 7 mounted under the movable rigid plane 6.

According to one embodiment of the supporting plane 6 of the abutment base 3 of the lamination chamber 2 the supporting plane 3a is designed with one or more grooves 15a for accommodating the corresponding irregular multilayer photovoltaic panels P to be manufactured. Furthermore, more than one supporting planes 3a having different configurations of grooves 15a can be provided and mounted in relation to the type of irregular multilayer photovoltaic panel P or irregular multilayer photovoltaic assembly to be manufactured. According to this embodiment, different supporting planes 3a can be interchanged in order to allow the abutment base 3 to support different type of irregular multilayer photovoltaic panels P or irregular multilayer photovoltaic assemblies.

According to another embodiment of the supporting plane 3a of the abutment base 3 of the lamination chamber 2, which is preferred over the embodiment of multiple and interchangeable different supporting planes 3a, the supporting plane 3a is provided with a supporting mould template 15 having at least one groove 15a for accommodating the projection portion P3 of the irregular multilayer photovoltaic panel P to be manufactured.

Advantageously, the supporting mould template 15 can be substituted with one or more different supporting mould templates 15 or with a plurality of supporting mould templates 15 to adapt the supporting plane 3a to an irregular multilayer photovoltaic panels P or an irregular multilayer photovoltaic assembly (not shown) presenting different configurations in the projection portions P3 with respect to the version of panel or assembly which is being manufactured.

In order to allow interchangeability of different versions of supporting mould templates 15 over the supporting plane 3a of the abutment base 3 of the lamination chamber 2, the supporting plane 3a is provided with suitable coupling devices (not shown) which allow the supporting mould templates 15 to be fixed to, or removed from, the supporting plane 3a. The arrangement of a supporting plane 3a with different supporting mould templates 15 interchangeable in relation to different sizes or different shapes or different configurations of irregular multilayer photovoltaic panels P or irregular multilayer photovoltaic assemblies to be manufactured makes the membranless laminator group 1 and also any plant of manufacturing 100 provided with such a membranless laminator group 1, universal and universally suitable for the production of a wide range of panels P or assemblies.

According to a further embodiment of the present disclosure, which can be applied either on the version having a supporting plane 3a of the abutment base 3 directly provided with a plurality of grooves 15a or on the version having a supporting mould template 15 provided with a plurality of grooves 15a, the grooves 15a are made in such number, shapes and arrangements as to provide for the different configurations that the multilayer and irregular photovoltaic panels P to be manufactured may have, especially in relation to the projecting portions P3 of the same. In this case, since the number of grooves 15a is greater than the number of the projecting portions P3 of each multilayer and irregular photovoltaic panel P to be manufactured, each groove 15a is advantageously covered by the application of a corresponding closure plate (not shown) in order to prepare the supporting mould template 15 or the supporting plane 3a to the specific configuration of the projecting portion(s) P3 of the multilayer and irregular photovoltaic panel P to be manufactured. Only the grooves 15a that are to actually accommodate respective projecting portions P3 of the panels in realization are left open, while the others are kept closed by their respective closure plates.

The movable rigid plane 6 of the lamination chamber 2 includes at least one heating device (not shown) which is activable for heating the movable rigid plane 6 and heating, by conduction, the mould template 7. The heating device of the movable rigid plane 6 is integrated, in particular embedded, into the body of the movable rigid plane 6.

Also the supporting plane 3a of the abutment base 3 of the lamination chamber 2 can be heated. In order to carry out the heating of the supporting plane 3a the latter can include at least one auxiliary heating device (not shown) which is properly activable. The auxiliary heating device is integrated, in particular embedded, into the body of the supporting plane 3a.

Furthermore, the lamination chamber 2 comprises at least one control mechanism 35 operatively connected to the movable rigid plane 6 to move the latter between the raised position (Figure 7) and the lowered position (Figure 8).

As shown in Figures 5 and 6, the control mechanism 35 comprises four dynamic fluid actuators 35a, in particular four of dynamic fluid cylinders and/or pistons, each mechanically connected to the movable rigid plane 6 of the lamination chamber 2 to move the latter between the raised position (Figure 7) and the lowered position (Figure 8) and to press, in the lowered position of the movable rigid plane 6, the irregular multilayer photovoltaic panel P lying on the supporting plane 3a of the abutment base 3 of the lamination chamber 2 to be manufactured. Each dynamic fluid cylinder and/or piston is located on and/or at the movable cover element 4 of the lamination chamber 2 and connected to the movable rigid plane 6 by a corresponding airtight through opening 40.

Moreover, the lamination chamber 2 comprises at least one compression mechanism 36 operatively active on the movable rigid plane 6 to press the latter towards the supporting plane 3a of the abutment base 3 when the movable rigid plane 6 is positioned in the lowered position (Figure 7). The compression mechanism 36 comprises a plurality of dynamic fluid actuators 36a, in particular a plurality of dynamic fluid cylinders and/or pistons, each adapted to operate on the movable rigid plane 6 to press the latter, in the lowered position of the movable rigid plane 6, against the irregular multilayer photovoltaic panel P lying on the supporting plane 3a. The dynamic fluid cylinder and/or piston of each dynamic fluid actuator 36a of the compression mechanism 36 is located on and/or at the movable cover element 4 of the lamination chamber 2 and is able to operate on the movable rigid plane 6 by a corresponding airtight through opening 41.

Due to the high temperature of working of the lamination chamber 2, thermal expansions of some components of the latter generally occur during every cycle of manufacturing. In order to compensate the relative movements occurred during the heating of the lamination chamber 2, the latter is provided with a plurality of thermal expansion compensation mechanisms 37 (Figures 9 to 11) properly configured to adjust at least the relative positions between the movable cover element 4 and the movable rigid plane 6 and/or to adjust at least the relative positions between the movable cover element 4 and a plurality of handling actuator 38a of an external handling device 38 which is arranged to drive the movable cover element 4 between the open position and the closed position. Each thermal expansion compensation mechanism 37 is triggered by the thermal expansion of the elements, parts, components or members of the lamination chamber 2 that occurs during the heating of the lamination chamber 2.

Some thermal expansion compensation mechanisms 37 comprise respective external thermal expansion compensation devices 37a, namely corresponding thermal expansion joints, each operatively located between the movable cover element 4 and a corresponding handling actuator 38a of the respective external handling device 38. Each external thermal expansion compensation device 37a is operatively located on a corresponding connection bracket 38b that joins a corresponding external handling device 38 with a corresponding external corner 4a of the movable cover element 4. In particular, each external thermal expansion compensation device 37a defines, together with two bracket potions 38c, 38d the corresponding connection bracket 38b.

Figure 9 shows an enlarged detail view of one connection bracket 38b of the lamination chamber 2 where it is possible to glimpse the corresponding external expansion compensation device 37a and how it is connected to a first portion 38c of the connection bracket 38b which is joined to the corresponding external corner 4a of the movable cover element 4 and to a second portion 38d of the connection bracket 38b which is joined to a corresponding handling actuator 38a of the corresponding external handling device 38.

In order to allow the external expansion compensation device 37a to be better visible, in Figure 9 the first portion 38c of the corresponding connection bracket 38b is removed.

Advantageously, each external thermal expansion compensation device 37a is configured to compensate the thermal expansions of the lamination chamber 2 at least along a compensation direction Z inclined with respect to orthogonal axis X, Y of a horizontal reference plane. In particular, the compensation direction Z is also inclined with respect to a travelling direction K of each irregular multilayer photovoltaic panel P to be manufactured and/or already manufactured. The orientation of the compensation direction Z, defined by each external thermal expansion compensation device 37a allows a corresponding relative movement between the movable cover element 4 and the corresponding handling actuator 38a of the external handling device 38 of the lamination chamber 2 which takes into account both the component of movements occurring along a direction parallel to the travelling direction K of each irregular multilayer photovoltaic panel P to be manufactured and/or already manufactured and the component of movements occurring along a direction perpendicular to the direction the travelling direction K.

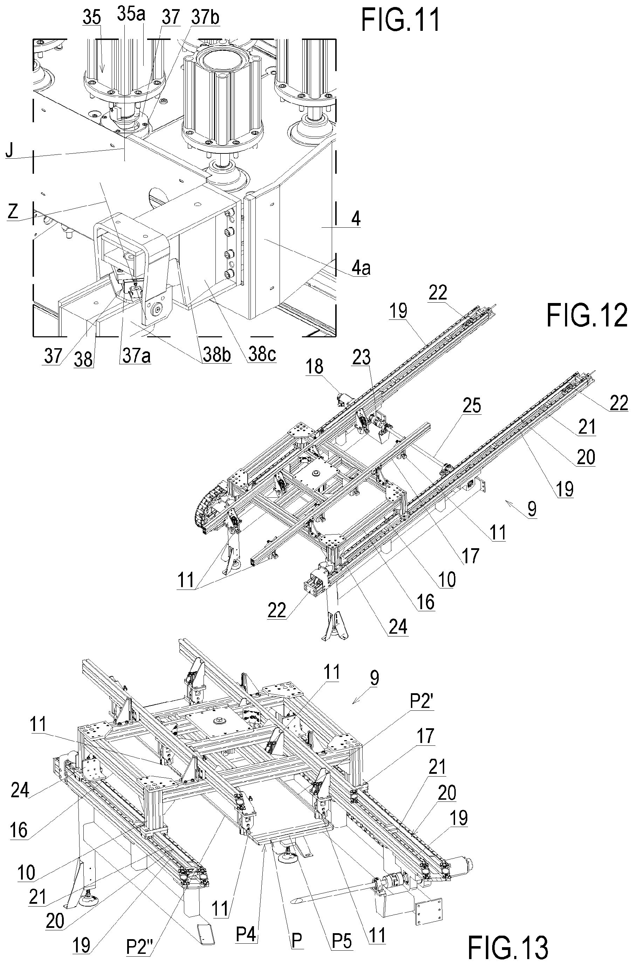

As shown in Figure 11, where a top wall 4b of the movable cover element 4 is removed, the thermal expansion compensation mechanism 37 also comprises a plurality of inner thermal expansion compensation devices 37b each operatively located between the top wall 4b of the movable cover element 4 and the movable rigid plane 6 of the lamination chamber 2. In particular, each inner thermal compensation device 37b is operatively associated to a corresponding dynamic fluid actuator 35a of the control mechanism 35 to act in correspondence of the region of connection between the latter and the movable rigid plane 6, preferably operatively interposed between the movable rigid plane 6 of the lamination chamber 2 and a corresponding dynamic fluid cylinder and/or piston of the dynamic fluid actuator 35a of the control mechanism 35 of the lamination chamber 2.

Similarly to the external thermal expansion compensation devices 37a, each inner thermal compensation device 37b is configured to compensate the thermal expansions of the lamination chamber 2 at least along an axuxiliary compensation direction J inclined with respect to orthogonal axis X, Y of a horizontal reference plane. In particular, the auxiliary compensation direction J is also inclined with respect to a travelling direction K of each irregular multilayer photovoltaic panel P to be manufactured and/or already manufactured.

The orientation of the compensation direction J, defined by each inner thermal expansion compensation device 37b allows a corresponding relative movement between the movable cover element 4 and the movable rigid plane 6 which takes into account both the component of movements occurring along a direction parallel to the travelling direction K of each irregular multilayer photovoltaic panel P to be manufactured and/or already manufactured and the component of movements occurring along a direction perpendicular to the direction the travelling direction K.

With reference to Figures 5 and 6, the membraneless laminator group 1 comprises a feeding unit 9 for supplying, one after the other, the irregular multilayer photovoltaic panels P or assemblies to be manufactured, to the lamination chamber 2 and a discharging unit 12 for removing, one after the other, the manufactured irregular multilayer photovoltaic panels P or assemblies from the lamination chamber 2. The feeding unit 9 is operatively located upstream the lamination chamber 2, whereas the discharging unit 12 is operatively located downstream the latter.

In particular, the feeding unit 9 comprises at least one feeding shuttle 10 movable between a picking-up position L1, wherein the feeding shuttle 10 is located outside the lamination chamber 2 to grip the protruding portions P2 of the irregular multilayer photovoltaic panel P to be supplied and a deposit position L2, wherein the feeding shuttle 10 is located inside the lamination chamber 2 to release the picked-up and supplied irregular multilayer photovoltaic panel P on the supporting plane 3a of the abutment base 3. The deposit position L2 is reachable by the feeding shuttle 10 of the feeding unit 9 only when the movable cover element 4 is positioned in the open position (Figure 7).

In order to provide a stable engagement and transport of each irregular multilayer photovoltaic panel P from the picking-up position L1 to the deposit position L2, the feeding unit 9 is provided with a plurality of gripping elements 11 operatively connected to the feeding shuttle 10, each operable like a clamp between a spread condition, wherein the gripping element 11 does not grip anything, and a tight condition, wherein the gripping element 11 grips the corresponding protruding portion P2 of the irregular multilayer photovoltaic panel P to be transported.

With reference to the enlarged view of the feeding unit 9 shown in Figures 12 and 13, the feeding shuttle 10 comprises a sliding structure 16 slidable between the picking-up position L1 and deposit position L2 and a supporting structure 17 operatively engaged to the sliding structure 16 for supporting the gripping elements 11. The supporting structure 17 is movable between a raised position, wherein the sliding structure 16 of the feeding shuttle 10 can be moved between the picking-up position L1 and the deposit position L2 with or without an irregular multilayer photovoltaic panel P gripped by the gripping element 11, and a lowered position, wherein the sliding structure 16 is held steady to allow an operation of picking-up or dropping an irregular multilayer photovoltaic panel P. Such operations are carried out by operating in correspondence of the protruding portions P2 of the irregular multilayer photovoltaic panels P.

The sliding structure 16 of the feeding shuttle 10 is driven by an electric motor 18, in particular a brushless electric motor, which allows high levels of accuracy in reaching the picking-up position L1 and, more importantly, in reaching the deposit position L2, wherein the feeding unit 9 has to ensure that each irregular multilayer photovoltaic panel P to be manufactured be placed on the supporting plane 3a of the abutment base 3 of the lamination chamber 2 at the same position of the previous manufactured irregular multilayer photovoltaic panels P and the followers irregular multilayer photovoltaic panels P to be manufactured.

With reference to the embodiment shown in Figures 5, 6, 12 and 13, the sliding structure 16 of the feeding shuttle 10 of the feeding unit 9 is slidable, by means of a plurality of corresponding sliders or carriages, along a couple of parallel sliding tracks 19 developing at least between the feeding unit 9 and the lamination chamber 2.

At least one transmission mechanism 20 is operable between the feeding shuttle 10 and the corresponding electric motor 18. The transmission mechanism 20 moves the feeding shuttle 10 between the picking-up position L1 and the deposit position L2 on electric motor 18 control.

In detail, the transmission mechanism 20 comprises, for each sliding track 19, at least one transmission belt 21 which develops along the corresponding sliding track 19 between two corresponding end transmission pulleys 22 operatively located on the corresponding sliding track 19. One end transmission pulley 22 is located close to or at the picking-up position L1 and the other end transmission pulley 22 is located close to or at the deposit position L2. The transmission belt 21 partially develops around each end transmission pulley 22 so that one forward branch and one return branch are defined on it 21 between the end transmission pulleys 22. The return branch of the transmission belt 21 partially develops around a drive pulley 23 operatively located on the corresponding sliding track 19. The drive pulley can be directly or indirectly connected to the corresponding electric motor 18 to be activated by the latter, when triggered, for moving the corresponding transmission belt 21. When the drive pulley 23 is indirectly connected to the electric motor 18, the power transmission is ensured by a transmission rod 25 or a drive shaft developing between the drive pulleys 23 of the sliding tracks 19.

The sliding structure 16 of the feeding shuttle 10 of the feeding unit 9 is fixed to the transmission belts 21 of the corresponding transmission mechanism 20 to be dragged into motion by the transmission belts 21 along the corresponding sliding tracks 19 between the picking-up position L1 and the deposit position L2. In particular, the sliding structure 16 of the feeding shuttle 10 engages the transmission belts 21 of the corresponding transmission mechanism 20 by a couple, one for each transmission belt 21, of fastening devices 24. Each fastening device 24 is openable and/or loosable to disengage the feeding shuttle 10 from the corresponding transmission belt 21, when necessary. With reference to Figures 5, 6, 14 and 15, the discharging unit 12 comprises a discharging shuttle 13 movable between a recovery position L3, wherein the discharging shuttle 13 is located inside the lamination chamber 2 to grip the protruding portions P2 of the manufactured irregular multilayer photovoltaic panel P lying on the supporting plane 3a of the abutment base 3 of the lamination chamber 2, and a deposit position L4, wherein the discharging shuttle 13 is located outside the lamination chamber 2 to release the recovered irregular multilayer photovoltaic panel P on a corresponding deposit region of the discharging unit 12. The recovery position L3 is reachable by the discharging shuttle 13 only when the movable cover element 4 is positioned in the open position (Figure 7).

In order to provide a stable engagement and transport of each irregular multilayer photovoltaic panel P from the recovery position L3 to the deposit position L4, the discharging unit 12 is provided with a plurality of gripping elements 14 operatively connected to the discharging shuttle 13, each operable like a clamp between a spread condition, wherein the gripping element 14 does not grip anything, and a tight condition, wherein the gripping element 14 grips the corresponding protruding portion P2 of the irregular multilayer photovoltaic panel P to be transported.

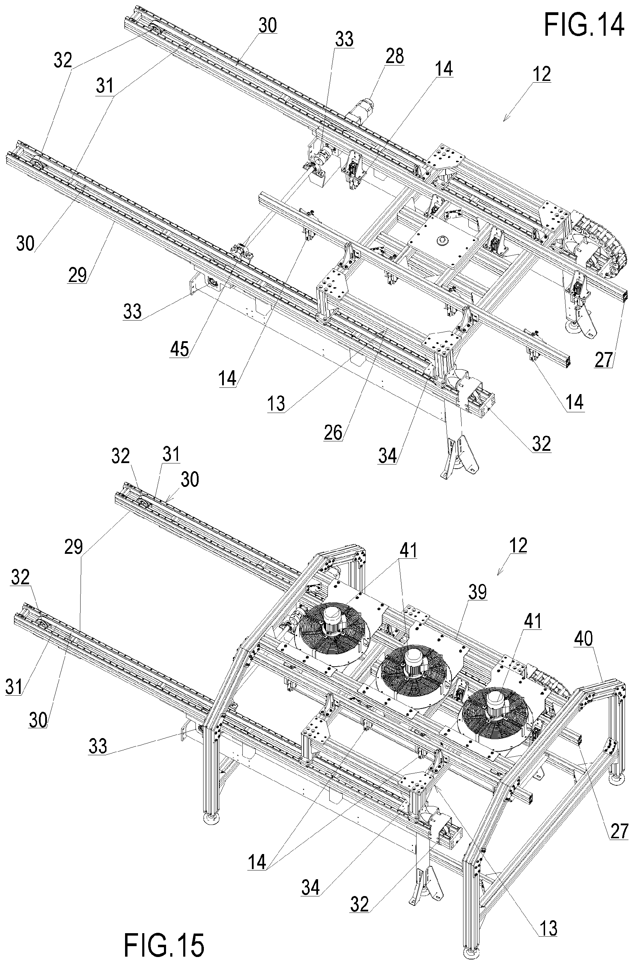

With reference to the enlarged view of the discharging unit 12 shown in Figures 14 and 15, the discharging shuttle 13 comprises a sliding structure 26 slidable between the recovery position L3 and deposit position L4 and a supporting structure 27 operatively engaged to the sliding structure 26 for supporting the gripping elements 14. The supporting structure 27 is movable between a raised position, wherein the sliding structure 26 of the discharging shuttle 13 can be moved between the recovery position L3 and the deposit position L4 with or without an irregular multilayer photovoltaic panel P gripped by the gripping elements 14, and a lowered position, wherein the sliding structure 26 is held steady to allow an operation of picking-up or dropping an irregular multilayer photovoltaic panel P. Such operations are carried out by operating in correspondence of the protruding portions P2 of the irregular multilayer photovoltaic panels P.

The sliding structure 26 of the discharging shuttle 13 is driven by an electric motor 28, in particular a brushless electric motor, which allows high levels of accuracy in reaching both the recovery position L3 and the deposit position L4. With reference to the embodiment shown in Figures 5, 6, 14 and 15, the sliding structure 26 of the discharging shuttle 13 of the discharging unit 9 is slidable, by means of a plurality of corresponding sliders or carriages, along a couple of parallel sliding tracks 29 developing at least between the discharging unit 9 and the lamination chamber 2.

At least one transmission mechanism 30 is operable between the discharging shuttle 13 and the corresponding electric motor 28. The transmission mechanism 30 moves the feeding shuttle 13 between the recovery position L3 and the deposit position L4 on electric motor 28 control.

In detail, the transmission mechanism 30 comprises, for each sliding track 29, at least one transmission belt 31 which develops along the corresponding sliding track 29 between two corresponding end transmission pulleys 32 operatively located on the corresponding sliding track 29. One end transmission pulley 32 is located close to, or at, the recovery position L1 and the other end transmission pulley 32 is located close to, or at, the deposit position L4. The transmission belt 31 partially develops around each end transmission pulley 32 so that one forward branch and one return branch are defined on it between the end transmission pulleys 32. The return branch of the transmission belt 31 partially develops around a drive pulley 33 operatively located on the corresponding sliding track 29. The drive pulley 33 can be directly or indirectly connected to the corresponding electric motor 28 to be activated by the latter when triggered for moving the corresponding transmission belt 31. When the drive pulley 33 is indirectly connected to the electric motor 28, the power transmission is ensured by a transmission rod or 45 a drive shaft developing between the drive pulleys 33 of the sliding tracks 29.

The sliding structure 26 of the discharging shuttle 13 of the discharging unit 12 is fixed to the transmission belts 31 of the corresponding transmission mechanism 30 to be dragged into motion by the transmission belts 31 along the corresponding sliding tracks 29 between the recovery position L3 and the deposit position L4. In particular, the sliding structure 26 of the discharging shuttle 13 engages the transmission belts 31 of the corresponding transmission mechanism 30 by a couple, one for each transmission belt 31, of fastening devices 34. Each fastening device 34 is openable and/or loosable to disengage the discharging shuttle 30 from the corresponding transmission belt 31, when necessary.

The deposit position L2 of the feeding shuttle 10 of the feeding unit 9 is substantially the same position as the recovery position L3 of the discharging shuttle 13 of the discharging unit 12. When the feeding shuttle 10 is located in the deposit position L1 inside the lamination chamber 2, the discharging shuttle 13 is located in the deposit position L4 outside the lamination chamber 2, vice versa when the discharging shuttle 13 is located in the recovery position L3 inside the lamination chamber 2, the feeding shuttle 10 of the feeding unit 9 is located in the picking-up position L1 outside the lamination chamber 2.

As shown in Figures 6, 7, 14 and 15, the discharging unit 12 can be provided with a cooling assembly 39, optionally an overstructure 40 with a plurality of cooling fans 41 ready to provide a forced air cooling to the irregular multilayer photovoltaic panel P which is deposited by the discharging shuttle 13 at the deposit position L4.

With reference to Figures 5 and 6, the sliding tracks 19 of the feeding unit 9 and the sliding tracks 29 of the discharging unit 12 are respectively aligned. In other words, the sliding tracks 19 of the feeding unit 9 are the continuation of the sliding tracks 29 of the discharging unit 12 and, vice versa the sliding tracks 29 of the discharging unit 12 are the continuation of the sliding tracks 19 of the feeding unit 9. However, even if the sliding tracks 19, 29 of the feeding unit 9 and the discharging unit 12 define an elongated sliding structure for the corresponding shuttles 10, 13, the corresponding transmission mechanisms 20, 30 define the limits of the movements of the corresponding shuttles 10. 13 along the elongated sliding structure.

According to an alternative embodiment not shown in the Figures, the feeding unit 9 and the discharging unit 12 can be defined by only one shuttle slidable along the sliding tracks among a picking-up position, wherein the shuttle 10 is located outside and upstream the lamination chamber 2 to grip the protruding portions P2 of the irregular multilayer photovoltaic panel P to be supplied, a chamber position wherein the shuttle is positioned at the lamination chamber 2 to deposit the supplied irregular multilayer photovoltaic panel P to be manufactured or to take the manufactured irregular multilayer photovoltaic panel P and, a deposit position located outside and downstream the lamination chamber 2, wherein the shuttle discharges the irregular multilayer photovoltaic panel P taken from the lamination chamber 2.

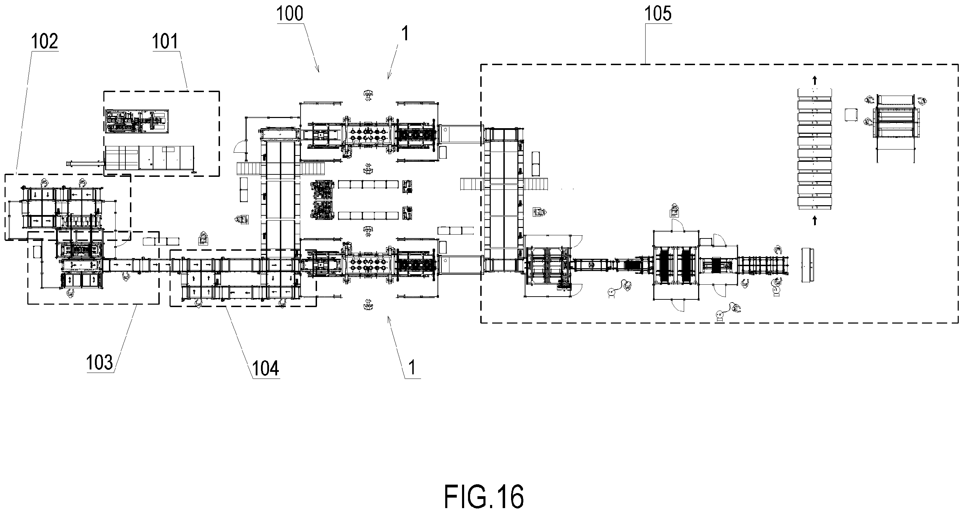

As shown in Figure 16, the present disclosure also refers to a plant 100 of manufacturing the above mentioned and describer irregular multilayer photovoltaic panels P.

The plant 100 comprises at least one arrangement station 101 wherein strings of photovoltaic cells are duly prepared according to the sizes and the best configuration for the irregular multilayer photovoltaic panels P to be manufactured. Downstream of the arrangement station 101, the plant 100 is provided with at least one welding station 102 wherein one or more strings of photovoltaic cells prepared at the arrangement station 101 is/are welded with corresponding bus bars.

Downstream of the welding station 102, the plant 100 comprises at least one setting station 103 wherein a plurality of layers of each irregular multilayer photovoltaic panel P to be manufactured is properly arranged above an aluminium travelling tray in a mutually overlapping relationship.

In particular, at the setting station 103, the preliminary formation of each irregular multilayer photovoltaic panel P is carried out by placing a corresponding supporting lamina P4 with the corresponding flat portion P1, protruding portions P2 and projection portion P3, directly over a corresponding aluminum travelling tray. Successively, a first encapsulating layer is arranged over the supporting lamina P4 and covered by a backsheet layer. After the backsheet layer, a second encapsulating layer is placed over the backsheet layer. Successively, a string of photovoltaic cells is arranged over the second encapsulating layer and covered by a third encapsulating layer. At the end, a glass layer is placed over the third encapsulating layer in order to define the sandwich of layers able to form irregular multilayer photovoltaic panel P to be manufactured.

Downstream of the setting station 103, the plant 100 can have a control station 104 where the strings of photovoltaic cells of each sandwich of layers formed at the setting station 103 are quality checked, preferably by means of known electro-luminescence techniques, to find any possible defect that might be present. Any sandwich of layers presenting one or more defects is temporarily discard and disassembled to be fixed or repaired or subjected to the string of photovoltaic cells replacement before being moved to at least one membraneless laminator group 1, as the one described in detail earlier, which is operative downstream the control station 104. Each sandwich of layers which does not present any defect is directly moved to the successive membraneless laminator group 1.

At the membraneless laminator group 1, each sandwich of layers coming from the control station 104 is properly supplied, one after the other, by the feeding unit 9 to the corresponding lamination chamber 2 after being separated from the corresponding travelling tray which is recovered and reused. At the lamination chamber 2, each sandwich of layers is subject to a deareation operation, a heating operation, and a pressing operation which is carried out by using the described above template mould 7 which presses only the corresponding flat portion P1 of the irregular multilayer photovoltaic panel P between the protruding portions P2', P2". Once the lamination cycle of the lamination chamber 2 ends, a corresponding irregular multilayer photovoltaic panel P is manufactured.

Each manufactured irregular multilayer photovoltaic panel P is then evacuated from the lamination chamber 2 by the corresponding discharging unit 12 to be sent to an evacuation and collecting area 105 located downstream of the membraneless laminator group 1.

## Claims

1. Membraneless laminator group (1) for making irregular multilayer photovoltaic panels (P) of the type having at least one flat portion (P1) and at least one protruding portion (P2) developing transversally with respect to the flat portion (P1), such as a protruding frame or one or more protruding edges, the membraneless laminator group (1) comprising at least one lamination chamber (2) configured to operate in vacuum, wherein the lamination chamber (2) comprises:
- an abutment base (3) provided with a supporting plane (3a) for supporting at least one irregular multilayer photovoltaic panel (P);
- a movable cover element (4) movable with respect to the abutment base (3) between an open position, wherein at least one irregular multilayer photovoltaic panel (P) can be inserted into the lamination chamber (2) or removed from the latter, and a closed position, wherein the movable cover element (4) engages the abutment base (3) by defining a sealable space (5), closed and isolated from the outside;
- a movable rigid plane (6) located inside the lamination chamber (2) and movable between a raised position, wherein the movable rigid plane (6) is spaced from supporting plane (3a) of the abutment base (3) and a lowered position, wherein the movable rigid plane (6) is close to the supporting plane (3a) of the abutment base (3); in an operating condition with an irregular multilayer photovoltaic panel (P) resting on the supporting plane (3a) of the abutment base (3) and the movable rigid plane (6) positioned in the lowered position, the irregular multilayer photovoltaic panel (P) being interposed between the movable rigid plane (6) and the supporting plane (3a) of the abutment base (3), in particular the irregular multilayer photovoltaic panel (P) being pressed between the movable rigid plane (6) and the supporting pane (3a) of the abutment base (3);
- at least one mould template (7) engageable or engaged to the movable rigid plane (6) so that to be located between the movable rigid plane (6) and the supporting plane (3a) of the abutment base (3) on which the irregular multilayer photovoltaic panel (P) to be manufactured is leaning on, the mould template (7) having a shape configured to adapt the movable rigid plane (6) to the irregular multilayer photovoltaic panel (P) to be manufactured, the mould template (7) being configured to transmit a pressure force from the movable rigid plane (6) to the at least one flat portion (P1) of the irregular multilayer photovoltaic panel (P) to be manufactured when the movable rigid plane (6) is positioned in the lowered position.

2. Membraneless laminator group (1) of claim 1, wherein the at least one mould template (7) has a flat shape, optionally a parallelepiped shape, more optionally a shape that at least in part lies within the outline of the at least one flat portion (P1) of the at least one irregular multilayer photovoltaic panel (P) to be manufactured, in particular a shape that completely lies within the outline of the at least one flat portion (P1) of the at least one irregular multilayer photovoltaic panel (P) to be manufactured, more in particular a shape substantially equal to the shape of the at least one flat portion (P1) of the at least one irregular multilayer photovoltaic panel (P) to be manufactured, optionally the at least one mould template (7) having an engaging surface (7a) faced to the supporting plane (3a) of the abutment base (3) substantially counter shaped to the at least one flat surface (P1) of the irregular multilayer photovoltaic panel (P) to be manufactured.

3. Membraneless laminator group (1) of any one of the previous claims, wherein the at least one mould template (7) has a thickness not less than the measurement of how far the at least one protruding portion (P2) projects with respect to the at least one flat portion (P1) of the at least one irregular multilayer photovoltaic panel (P) to be manufactured, the at least one mould template (7) being interposed between the movable rigid plane (6) and the floppy adaptive element (8).

4. Membraneless laminator group (1) of any one of the previous claims, wherein the lamination chamber (2) also comprises a floppy adaptive element (8) engageable or engaged at least on opposite sides (6a) of the movable rigid plane (6), in particular, the floppy adaptive element (8) being engageable or engaged at least on two perimetric portions of the movable rigid plane (6), optionally, the at least one mould template (7) being interposed between the movable rigid plane (6) and the floppy adaptive element (8).

5. Membraneless laminator group (1) of the previous claim, wherein:
- in the open position of the movable cover element (4) and/or in the raised position of the movable rigid plane (6), the floppy adaptive element (8) hangs from the movable rigid plane (6) towards the supporting plane (3a) of the abutment base (3) so that to define an arched configuration with a convexity (8a) facing towards the supporting plane (3a) of the abutment base (3) and a concavity space (8b) between the at least the mould template (7) and the floppy adaptive element (8);
- in the lowered position of the movable rigid plane (6), the floppy adaptive element (8) is pressed between the at least one mould template (7) and the at least one irregular multilayer photovoltaic panel (P) to be manufactured lying on the supporting plane (3a) of the abutment base (3), in particular, the pressed floppy adaptive element (8) defining a layer of seal covering completely the at least one flat portion (P1) and, at least partially, the at least one protruding portion (P2) of the irregular multilayer photovoltaic panel (P) to be manufactured.

6. Membraneless laminator group (1) of any one of the previous two claims, wherein the floppy adaptive element (8) is made of a flexible material, optionally a deformable material, in particular the floppy adaptive element (8) being made in the shape of a carpet or a belt or a tape.

7. Membraneless laminator group (1) of any one of the previous three claims, wherein the floppy adaptive element (8) is made of silicone, optionally resistant to high temperatures, more optionally resistant to a temperature comprised between 100° C and 400° C, in particular comprised between 110° C and 350° C, more in particular comprised between 120° C and 300° C, preferably comprised between 140° C and 250° C.

8. Membraneless laminator group (1) of any one of the previous claims, wherein the mould template (7) can be substituted with a different mould template (7) suitable for manufacturing at least one irregular multilayer photovoltaic panel (P) having one or more flat portions (P1) and one or more protruding portions (P2) different with respect to the ones of the at least one irregular multilayer photovoltaic panel (P) which is being manufactured.

9. Membraneless laminator group (1) of any one of the previous claims, wherein the abutment base (3) the lamination chamber (2) is provided with at least one groove (15a) for accommodating at least one projection portion (P3) of the at least one irregular multilayer photovoltaic panel (P) transversally developing with respect the flat portion (P1) on the opposite side of the protruding portion (P2), the groove (15a) allowing the at least one irregular multilayer photovoltaic panel (P) to lie on the supporting plane (3a) of the abutment base (3) parallel to the latter, in particular according to a horizontal plane, optionally the supporting plane (3a) of the abutment base (3) of the lamination chamber (2) can be substituted with a different supporting plane (3a) for manufacturing at least one irregular multilayer photovoltaic panel (P) having one or more flat portions (P1) and one or more projecting portions (P3) different with respect to the ones of the at least one irregular multilayer photovoltaic panel (P) which is being manufactured, more optionally the supporting plane (3a) of the abutment base (3) of the lamination chamber (2) can be substituted with a supporting plane (3a) having a different configuration of the groove (15a) or of the grooves (15a) being adapted to manufacture irregular multilayer photovoltaic panels (P) having one or more projecting portions (P3) different with respect to the ones of the at least one irregular multilayer photovoltaic panel (P) which is being manufactured.

10. Membraneless laminator group (1) of any one of the previous claims, wherein the supporting plane (3a) of the abutment base (3) is provided with a supporting mould template (15) provided with at least one groove (15a) for accommodating at least one projection portion (P3) of the at least one irregular multilayer photovoltaic panel (P) transversally developing with respect to the flat portion (P1) on the opposite side of the protruding portion (P2), the groove (15a) allowing the at least one irregular multilayer photovoltaic panel (P) to lie on the supporting plane (3a) of the abutment base (3) parallel to the supporting plane (3a), in particular according to a horizontal plane, optionally the supporting mould template (15a) can be substituted with a different supporting mould template (15a) for manufacturing at least one irregular multilayer photovoltaic panel (P) having one or more flat portions (P1) and one or more projecting portions (P3) different with respect to the ones of the at least one irregular multilayer photovoltaic panel (P) which is being manufactured, more optionally the supporting mould template (15) can be substituted with a supporting mould template (15) having a different configuration of the groove (15a) or of the grooves (15a) being adapted to manufacture irregular multilayer photovoltaic panels (P) having one or more projecting portions (P3) different with respect to the ones of the at least one irregular multilayer photovoltaic panel (P) which is being manufactured.

11. Membraneless laminator group (1) of any one of the previous claims, wherein the membraneless laminator group (1) comprises:
- a feeding unit (9) for supplying at least one irregular multilayer photovoltaic panel (P) to be manufactured to the lamination chamber (2), the feeding unit (9) comprising at least one feeding shuttle (10) movable between a picking-up position (L1), wherein the feeding shuttle (10) is located outside the lamination chamber (2) to grip the at least one protruding portion (P2) of an irregular multilayer photovoltaic panel (P) to be supplied and a deposit position (L2), wherein the feeding shuttle (10) is located inside the lamination chamber (2) of the membraneless laminator group (1) to release the picked-up irregular multilayer photovoltaic panel (P) on the supporting plane (3a) of the abutment base (3) of the lamination chamber (2), the deposit position being reachable by the feeding shuttle (10) of the feeding unit (9) only when the movable cover element (4) is positioned in the open position;
- a discharging unit (12) for removing at least one irregular multilayer photovoltaic panel (P) from the lamination chamber (2), the discharging unit (12) comprising a discharging shuttle (13) movable between a recovery position (L3), wherein the discharging shuttle (13) is located inside the lamination chamber (2) to grip the at least one protruding portion (P2) of the manufactured irregular multilayer photovoltaic panel (P) lying on the supporting plane (3a) of the abutment base (3) of the lamination chamber (2) and a deposit position (L4), wherein the discharging shuttle (13) is located outside the lamination chamber (2) to release the recovered irregular multilayer photovoltaic panel (P) on a corresponding deposit region of the discharging unit (12), the recovery position (L3) being reachable by the discharging shuttle (13) of the discharging unit (12) only when the movable cover element (4) is positioned in the open position.

12. Membraneless laminator group (1) of the previous claim, wherein the deposit position (L2) of the feeding shuttle (10) of the feeding unit (9) is substantially the same position as the recovery position (L3) of the discharging shuttle (13) of the discharging unit (12), when the feeding shuttle (10) of the feeding unit (9) is located in the deposit position (L1) inside the lamination chamber (2), the discharging shuttle (13) of the discharging unit (12) is located in the deposit position (L4) outside the lamination chamber (2), vice versa when the discharging shuttle (13) of the discharging unit (10) is located in the recovery position (L3) inside the lamination chamber (2), the feeding shuttle (10) of the feeding unit (9) is located in the picking-up position (L1) outside the lamination chamber (2).

13. Membraneless laminator group (1) of any one of the previous two claims, wherein:
- the feeding unit (9) comprises at least one gripping element (11) operatively connected to the feeding shuttle (10), in particular two or more gripping elements (11) or a plurality of gripping elements (11), each operable between a spread condition, wherein the gripping element (11) does not grip anything, and a tight condition, wherein the gripping element (11) grips the at least one protruding portion (P2) of a corresponding irregular multilayer photovoltaic panel (P), optionally the feeding shuttle (10) of the feeding unit (9) comprising:
∘ a sliding structure (16) slidable between the picking-up position (L1) and the deposit position (L2);
∘ a supporting structure (17) operatively engaged to the sliding structure (16) and supporting the at least one gripping element (11), optionally each gripping element (11), the supporting structure (17) being movable between a raised position, wherein the sliding structure (16) of the feeding shuttle (10) can be moved between the picking-up position (L1) and the deposit position with or without an irregular multilayer photovoltaic panel (P) gripped by the gripping element (11) and a lowered position, wherein the sliding structure (16) is held steady to allow an operation of picking-up an irregular multilayer photovoltaic panel (P) or an operation of dropping an irregular multilayer photovoltaic panel (P), more optionally, the sliding structure (16) of the feeding shuttle (10) being slidable along at least one sliding track (19), in particular a couple of parallel sliding tracks (19), developing at least between the feeding unit (9) and the lamination chamber (2), in particular the sliding structure (16) engaging the at least one sliding track (19) by means of at least one corresponding slider or a carriage;
- the discharging unit (12) comprises at least one gripping element (14) operatively connected to the discharging shuttle (13), in particular two or more gripping elements (14) or a plurality of gripping elements (14), each operable between a spread condition, wherein the gripping element (14) does not grip anything, and a tight condition, wherein the gripping element (14) grips the at least one protruding portion (P2) of a corresponding irregular multilayer photovoltaic panel (P), optionally the discharging shuttle (13) of the discharging unit (12) comprising:
∘ a sliding structure (26) slidable between the recovery position (L3) and the deposit position (L4);
∘ a supporting structure (27) operatively engaged to the sliding structure (26) and supporting the gripping element (14), optionally each gripping element (14), the supporting structure (27) being movable between a raised position, wherein the sliding structure (26) of the discharging shuttle (13) can be moved between the recovery position (L3) and the deposit position (L4) with or without an irregular multilayer photovoltaic panel (P) gripped by the gripping element (14) and a lowered position, wherein the sliding structure (26) is held steady to allow an operation of picking-up an irregular multilayer photovoltaic panel (P) or an operation of dropping an irregular multilayer photovoltaic panel (P), more optionally, the sliding structure (26) of the discharging shuttle (13) of the discharging unit (12) is slidable along at least one sliding track (29), optionally a couple of parallel sliding tracks (29), developing at least between the discharging unit (12) and the lamination chamber (2), in particular the sliding structure (26) engaging the at least one sliding track (29) by means of at least one corresponding slider and/or a carriage.

14. Plant (100) of manufacturing irregular multilayer photovoltaic panel (P) of the type having at least one flat portion (P1) and at least one protruding portion (P2) developing transversally with respect to the flat portion (P1), such as a protruding frame or one or more protruding edges, the plant (100) of manufacturing comprising:
- at least one arrangement station (101) wherein one or more strings of photovoltaic cells are prepared;
- at least one welding station (102) wherein one or more strings of photovoltaic cells prepared at the arrangement station (101) is/are welded with corresponding bus bars;
- at least one setting station (103) wherein a plurality of layers of each irregular multilayer photovoltaic panel (P) to be manufactured is arranged above a travelling tray in a mutually overlapping relationship, in particular, a supporting lamina (P4), optionally metallic, being arranged directly onto a corresponding travelling tray, a first encapsulating layer being arranged over the supporting lamina (P4), a backsheet layer being arranged over the first encapsulating layer, a second encapsulating layer being arranged over the backsheet layer, one or more strings of photovoltaic cells being arranged over the second encapsulating layer, a third encapsulating layer being arranged over one or more strings of photovoltaic cells and a glass layer being arranged over the third encapsulating layer;
- a membraneless laminator group (1) comprising at least one lamination chamber (2) configured to operate in vacuum, wherein the lamination chamber (2) comprises:
∘ an abutment base (3) provided with a supporting plane (3a) for supporting at least one irregular multilayer photovoltaic panel (P);
∘ a movable cover element (4) movable with respect to the abutment base (3) between an open position, wherein at least one irregular multilayer photovoltaic panel (P) can be inserted into the lamination chamber (2) or removed from the latter, and a closed position, wherein the movable cover element (4) engages the abutment base (3) by defining a sealable space (5), closed and isolated from the outside;
∘ a movable rigid plane (6) located inside the lamination chamber (2) and movable between a raised position, wherein the movable rigid plane (6) is spaced from the supporting plane (3a) of the abutment base (3) and a lowered position, wherein the movable rigid plane (6) is close to the supporting plane (3a) of the abutment base (3); in an operating condition with an irregular multilayer photovoltaic panel (P) resting on the supporting plane (3a) of the abutment base (3) and the movable rigid plane (6) in the lowered position, the irregular multilayer photovoltaic panel (P) being interposed between the movable rigid plane (6) and the supporting plane (3a) of the abutment base (3), in particular the irregular multilayer photovoltaic panel (P) being pressed between the movable rigid plane (6) and the supporting plane (3a) of the abutment base (3);
∘ at least one mould template (7) engageable or engaged to the movable rigid plane (6) so that to be located between the movable rigid plane (6) and the supporting plane (3a) of the abutment base (3) on which the irregular multilayer photovoltaic panel (P) to be manufactured is leaning on, the mould template (7) having a shape configured to adapt the movable rigid plane (6) to the irregular multilayer photovoltaic panel (P) to be manufactured, the mould template (7) being configured to transmit a pressure force from the movable rigid plane (6) to the at least one flat portion (P1) of the irregular multilayer photovoltaic panel (P) to be manufactured when the movable rigid plane (6) is in the lowered position;
∘ optionally, a floppy adaptive element (8) engageable or engaged at least on opposite sides (6a) of the movable rigid plane (6), the mould template (7) being interposed between the movable rigid plane (6) and the floppy adaptive element (8), in the open position of the movable cover element (4) and/or in the raised position of the movable rigid plane (6), the floppy adaptive element (8) hanging from the movable rigid plane (6) towards the supporting plane (3a) of the abutment base (3) so that to define an arched configuration with a convexity (8a) facing towards the supporting plane (3a) of the abutment base (3), in the lowered position of the movable rigid plane (6) the floppy adaptive element (8) being pressed between the mould template (7) and the irregular multilayer photovoltaic panel (P) to be manufactured, defining a layer of seal which covers the at least one flat portion (P1) and, at least partially, the at least one protruding portion (P2) of the irregular multilayer photovoltaic panel (P) so as to evenly distribute the pressure forces on the latter;
∘ a feeding unit (9) for supplying at least one irregular multilayer photovoltaic panel (P) to be manufactured to the lamination chamber (2), the feeding unit (9) comprising at least one feeding shuttle (10) movable between a picking-up position (L1), wherein the feeding shuttle (10) of the feeding unit (9) is located outside the lamination chamber (2) to grip, by means of at least one gripping element (11), the at least one protruding portion (P2) of an irregular multilayer photovoltaic panel (P) to be supplied and a deposit position (L2), wherein the feeding shuttle (10) is located inside the lamination chamber (2) of the membraneless laminator group (1) to release the picked-up irregular multilayer photovoltaic panel (P) on the supporting plane (3a) of the abutment base (3) of the lamination chamber (2), the deposit position (L2) being reachable by the feeding shuttle (10) of the feeding unit (9) only when the movable cover element (4) is in the open position, at the feeding unit (9), the travelling tray being recovered from the irregular multilayer photovoltaic panel (P) to be reused again at the setting station (103) after the gripping element (11) of the feeding shuttle (10) has taken the at least one protruding portion (P2) of the irregular multilayer photovoltaic panel (P) to be supplied to the lamination chamber (2);
∘ a discharging unit (12) for removing at least one irregular multilayer photovoltaic panel (P) from the lamination chamber (2), the discharging unit (12) comprising a discharging shuttle (13) movable between a recovery position (L3), wherein the discharging shuttle (13) is located inside the lamination chamber (2) to grip, by means of at least one gripping element (14), the at least one protruding portion (P2) of the manufactured irregular multilayer photovoltaic panel (P) lying on the supporting plane (3a) of the abutment base (3) of the lamination chamber (2) and a deposit position (L4), wherein the discharging shuttle (13) of the discharging unit (12) is located outside the lamination chamber (2) to release the recovered irregular multilayer photovoltaic panel (P) on a corresponding deposit region of the discharging unit (12), the recovery position (L3) being reachable by the discharging shuttle (13) of the discharging unit (12) only when the movable cover element (4) is positioned in the open position.

15. A method of manufacturing irregular multilayer photovoltaic panels (P) of the type having at least one flat portion (P1) and at least one protruding portion (P2) developing transversally with respect to the flat portion (P1), such as a protruding frame or one or more protruding edges, comprises the following steps:
- preparing at least one irregular multilayer photovoltaic panel (P) by placing a plurality of layers over a travelling tray in a mutually overlapping relationship, in particular the preparing step being defined by positioning a supporting lamina (P4), optionally metallic, directly onto a corresponding travelling tray and a plurality of layers, including one or more strings of photovoltaic cells, over the supporting lamina (P4), the supporting lamina (P4) defining the protruding portions (P2) of the irregular multilayer photovoltaic panel (P) to be manufactured;
- supplying the prepared irregular multilayer photovoltaic panel (P) to a lamination chamber (2) of a membraneless lamination group (1) configured to operate in vacuum, wherein at the lamination chamber (2) each supplied irregular multilayer photovoltaic panel (P) to be manufactured, is subject to a deareation operation, a heating operation and a pressing operation, the pressing operation being carried out by using at least one template mould (7) which presses only the corresponding flat portion (P1) of the irregular multilayer photovoltaic panel (P) avoiding to press the protruding portion (P2) thereof, the supplying step being anticipated by a separation step of the travelling tray from the supporting lamina (P4) which is carried out by directly gripping the protruding portion (P2) of each irregular multilayer photovoltaic panel (P) to be manufactured, the travelling tray being recovered for reuse;
- removing each manufactured irregular multilayer photovoltaic panel (P) from the lamination chamber (2) by directly gripping the protruding portion (P2) thereof.
